(19) Europäisches Patentamt
European Patent Office
Office européen des brevets

(11) **EP 2 779 553 B1**

(12) **EUROPEAN PATENT SPECIFICATION**

(45) Date of publication and mention
of the grant of the patent:
**02.05.2018 Bulletin 2018/18**

(51) Int Cl.:
*H04L 25/06* *(2006.01)*     *H04L 27/36* *(2006.01)*

(21) Application number: **14158207.2**

(22) Date of filing: **06.03.2014**

(54) **DC bias estimation of a radio frequency mixer**

Geichstromvorspannungsschätzung eines Funkfrequenzmischers

Estimation de polarisation CC d'un mélangeur de fréquence radio

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **14.03.2013   US 201313828989**

(43) Date of publication of application:
**17.09.2014   Bulletin 2014/38**

(73) Proprietor: **Analog Devices Global Unlimited
Company
Hamilton (BM)**

(72) Inventors:
• **Primo, Haim**
  **Ganei Tikva (IL)**
• **Manglani, Manish J.**
  **Greensboro, NC 27407 (US)**
• **Stein, Yosef**
  **Sharon, MA  02067 (US)**

(74) Representative: **Wardle, Callum Tarn et al
Withers & Rogers LLP
4 More London Riverside
London
SE1 2AU (GB)**

(56) References cited:
**US-A1- 2002 018 531     US-B1- 6 801 581
US-B1- 7 035 589        US-B1- 7 382 833**

**Description**

BACKGROUND

Description of the Related Technology

Many electronic systems operate with radio-frequency (RF) signals. Such electronic systems can include an RF transmitter that generates a wireless or wired signal (for example, a radio frequency signal) for wireless transmission or wired transmission. An RF transmitter can include various components to amplify, filter, and modulate one or more baseband signals to be transmitted to generate an RF transmit signal that carries the data. For example, an RF transmitter can use quadrature modulation in which two baseband signals are modulated one separate paths using mixers operating with 90° phase offset to generate an in-phase channel ("I-channel") signal and a quadrature-phase channel ("Q-channel") signal. The I-channel and Q-channel signals are combined for transmission. In addition to mixers, the I path and the Q path can also include various other electronics, such as amplifiers and filters.

In an RF transmitter such as a direct-conversion transmitter, I/Q direct current (DC) offset and imbalance can occur, for example, when the transfer function of the I path of the transmitter is different from that of the Q path of the transmitter. Offset and imbalance can occur due to imperfections and variability of the analog components of an RF transmitter, such as the filters, mixers, amplifiers, and digital-to-analog converts ("DACs"), resulting in an asymmetrical transmitter circuit with respect to the I and Q paths. Sources of such offsets and imbalances include, but are not limited to, gain and phase mismatch of the mixers, frequency responses of low-pass filters, gain and offset of DACs, DAC-clock timing mismatch, and a non-linear I/Q imbalance.

There have been various attempts to reduce or eliminate DC offset from mixers of RF transmitters. Among others, digital signal processing techniques have been used to reduce DC offset. Some of these techniques focus on generating an offset compensation signal by performing sweeps of the compensation signal to identify a nulling signal. Other techniques attempt to compensate for DC offset by performing a moving average computation on the transmit signal.

US 6,801,581 describes a transmitter having a transmission path with an IQ modulator and a feedback path with an IQ demodulator. DC offset is determined by estimating a DC offset of the IQ demodulator, adaptively estimating a DC offset of the IQ modulator at least partially from the demodulator DC offset, subtracting the estimated demodulator DC offset from the feedback path and subtracting the estimated modulator DC offset from the transmission path.

Patent application US 2002/00018531 A1 describes a method and an arrangement for determining correction parameters used for correcting DC-offset of an I/Q modulator in a transmitter comprising an I/Q modulator and a corrector for correcting the DC-offset caused by the I/Q modulator.

US 7,382,833 B1 related to a quadrature modulator compensation system for compensating the transmitter of a course signal including a transmitter which uses a transmitter input signal to generate a transmitter output. Calibration circuitry generates at least one of a phase error estimate of the transmitter, a gain error estimate of the transmitter, and a dc offset estimate.

US 7,035,589 B1 describes a method and system for reducing the DC offset in a receiver in the presence of a carrier frequency offset between the transmitter and the receiver. Knowledge of the carrier frequency offset is used to determine the phase difference between two or more snapshots of the same transmitted symbol. The receiver DC offset is solved for using a linear system solver which can be implemented outside the analog domain.

SUMMARY

Without limiting the scope of this invention as expressed by the claims which follow, some features will now be discussed briefly. After considering this discussion, and particularly after reading the section titled "Detailed Description," one will understand how the features of this invention provide advantages that include improving transmit signal quality by reducing the effects of biases of RF converter mixers.

The present invention provides a method, apparatus and a computer program as defined in claims 1, 6 and 9. Further improvements and embodiments are provided in the dependent claims.

According to an aspect of the invention there is provided an electronically-implemented method for generating an estimate for a direct current (DC) offset in an RF transmitter, the method comprising: receiving samples of a first signal (r), wherein the first signal includes a downconverted and filtered RF transmit signal ($s_t$) having an in-phase (I) channel and a quadrature (Q) channel; low-pass filtering and decimating the received samples of the first signal; retrieving values of a second signal ($l_i$) that correspond in time to the samples of the first signal, wherein the second signal includes an I-channel compensation signal ($l_i$); generating an estimate of a I-channel DC offset ($i_{DC}$) induced by a first mixer (102) based at least partly on at least two selected samples of the first signal (r) and the corresponding values of the second signal ($l_i$); and adding the I-channel DC offset estimate ($i_{DC}$) to the I-channel of the RF transmit signal ($s_{ti}$), characterized in that the method further comprises: receiving the low-pass filtered and decimated samples ($r_{ip}$) of the first signal at an averaging filter (310) and receiving an output of the averaging filter ($r_a$) at an integration filter (312), the I-channel DC offset ($i_{DC}$) being generated at least partly on the output of the integration filter (n).

The method may further comprise retrieving values of a third signal that correspond in time to the samples of the first signal, wherein the third signal includes a Q-channel compensation signal, generating an estimate of a Q-channel DC offset induced by a second mixer based at least partly on at least two selected samples of the first signal and the corresponding values of the third signal and the output of the integration filter, and adding the Q-channel DC offset estimate to the Q-channel of the RF transmit signal.

Additionally or alternatively, the method may further comprise generating the first signal, wherein the generating the first signal comprises using a calibrated downconverter to downconvert the RF transmit signal after the RF transmit signal has been upconverted, wherein the downconverter receives first and second carrier signals that are received by the respective first and second mixers.

Additionally or alternatively, generating the estimate of a first DC offset may be based at least partly on a selected mode of two or more modes of operation, wherein the two or more modes of operation include a calibration mode and a tracking mode.

Additionally, receiving the samples of the first signal may comprise receiving a first sample of the first signal by generating samples of the first signal after the second signal takes on a first value for a first duration, and receiving a second sample of the first signal by generating samples of the first signal after the second signal takes on a second value for a second duration, wherein the first value is different than the second value, wherein the generating the estimate of the I-channel DC offset when the selected mode is the calibration mode is based at least partly on a first comparison between squared magnitudes of the first and second samples of the first signal and based at least partly on a second comparison between the first and second values of the second signal.

According to another aspect of the invention there is provided an apparatus for generating an estimate for a direct current (DC) offset in an RF transmitter comprising: an interface (122) configured to: receive samples of a first signal (r) and values of a second signal that correspond in time to the samples of the first signal, wherein the first signal includes a downconverted and filtered RF transmit signal ($s_t$) having an in-phase (I) channel and a quadrature (Q) channel, and wherein the second signal includes an I-channel compensation signal ($I_i$); and apply low-pass filtering decimation to the received samples of the first signal (r); an offset estimator (124) configured to: generate an estimate of an I-channel DC offset ($i_{DC}$) induced by a first mixer (102) based at least partly on at least two selected samples of the first signal (r) and the corresponding values of the second signal ($I_i$); and add the I-channel DC offset estimate ($i_{DC}$) to the I-channel of the RF transmit signal, characterized in that: the interface includes: an averaging filter (310) configured to receive the low-pass filtered and decimated samples of the first signal; and an integration filter (312) configured to receive an output of the averaging filter, wherein the I-channel DC offset ($i_{DC}$) is generated at least partly on the output of the integration filter.

Additionally or alternatively, the offset estimator may be configured to receive a first sample of the first signal by generating the first sample after the second signal takes on a first value for a first duration, and configured to receive a second sample of the first signal by generating the first sample after the second signal takes on a second value for a second duration, wherein the first value is different than the second value, wherein the offset estimator is configured to generate the estimate of the I-channel DC offset based at least partly on a first comparison between a squared magnitudes of the first and second samples of the first signal and based at least partly on a second comparison between the first and second values of the second signal.

Additionally or alternatively, the offset estimator may be configured to selectively operate a tracking mode, wherein the offset estimator is configured to generate the estimate of the first DC offset iteratively by generating a plurality of adjustments, wherein the adjustments are based at least partly on the at least two selected samples of the first signal and corresponding values of the second signal.

According to a further aspect of the invention there is provided a computer program embodied in a tangible non-transitory computer-readable medium for generating an estimate for a direct current (DC) offset, the computer program comprising computer executable instructions that when executed by a data processor course the data processor to perform the previously described method.

BRIEF DESCRIPTION OF THE DRAWINGS

These drawings and the associated description herein are provided to illustrate specific embodiments of the invention and are not intended to be limiting.

Figure 1 is a schematic block diagram illustrating a model of an upconverter offset compensation system of a radio frequency transmitter including a model of DC offsets.
Figure 2 is a schematic block diagram illustrating a downconverter of Figure 1 in accordance with one embodiment.
Figure 3 is a schematic block diagram illustrating the preprocessor and the offset estimator of Figure 1 in accordance with one embodiment.

Figure 4 is a schematic diagram illustrating the offset compensator of Figure 1 in accordance with one embodiment.

Figure 5 is a system diagram illustrating one embodiment of a processor-based system for implementing the preprocessor and the offset estimator of Figures 1 and 3.

Figure 6 is a flow diagram illustrating a method for estimating an offset of an upconverter mixer in accordance with yet another embodiment.

Figure 7 is a flow diagram illustrating one embodiment of a process for generating estimate from samples of a filtered model receive signal.

Figure 8 is a flow diagram illustrating one embodiment of a process for estimating offset calibration during a calibration mode.

Figure 9 is a diagram illustrating a sampling schedule in accordance with one embodiment.

Figure 10 is a flow diagram illustrating a process for estimating offset adjustment during a tracking mode in accordance with embodiments.

DETAILED DESCRIPTION OF EMBODIMENTS

The following detailed description of certain embodiments presents various descriptions of specific embodiments of the invention. However, the invention can be embodied in a multitude of different ways as defined and covered by the claims. In this description, reference is made to the drawings where like reference numerals may indicate identical or functionally similar elements.

Embodiments relate to and are described in the context of systems and methods for estimating direct current ("DC") offset of a converter mixer of a radio frequency ("RF") transmitter and will also be applicable to transmitter-receivers and to transceivers. DC offsets can occur independently in each of the communication channels of the RF transmitter. For example, in a quadrature modulation-based transmitter, DC offsets can occur in one of or both the in-phase ("I") channel and the quadrature-phase ("Q") channel. DC offsets can manifest as a portion of unmodulated carrier signal appearing at the output of the upconverter circuit. In one embodiment, the system compensates for DC offset by estimating the DC offset and then subtracting out the estimated DC offset term at the upconverter inputs in order to attenuate or at least partially negate the effects of DC offset at the upconverter output.

In one particular embodiment, the system generates estimates of a DC offset by demodulating an RF transmit signal, filtering and processing the demodulated transmit signal, estimating the DC offset based on the processed signals, and the using the estimates of the DC offset to subtract out the actual DC offset. For example, the RF transmit signal can be generated with "test" or "probe" compensation signals added to I/Q baseband signals, and then upconverting the result to generate an RF transmit signal. In the presence of a DC offset for the upconverter, the RF transmit signal should also contain the undesirable DC offset terms. The RF transmit signal can be demodulated to baseband so that the DC offset terms appear as DC components. In one embodiment, the RF transmit signal can be demodulated using a model of an RF receiver circuit having fully calibrated downconverters (also referred to as a demodulator or a mixers) for demodulating the RF transmit signal without substantially introducing additional sources of DC offset. The system then preprocesses the demodulated signal to prepare the signal for DC offset estimation. The preprocessed or filtered signal is sampled two or more times. The samples and the compensation signals are used to calculate an estimate the DC offset of the converter mixer of the RF transceiver.

In some examples, the preprocessing can include using a number of analog and/or digital filters to remove components of the signal extraneous to DC offset estimation, such as electronic noise, transmit data, and other signal components, which can adversely affect DC offset estimation. The extraneous signal components can have frequencies substantially above DC. These extraneous components can be attenuated by using one or more low-pass filters to reject frequencies substantially above DC and pass frequencies that are close to DC, thereby retaining the DC-offset relevant information of the signal. The system can decimate or downsample the signal between filtering. For example, decimation can be used where filtering reduces the bandwidth of an intermediate preprocessed signal. A decimated signal can reduce computational costs associated with DC offset estimation.

In further examples, the system can operate in either a calibration mode or in a tracking mode. For example, operating in a calibration mode can allow the system to rapidly generate an estimate of the DC offset. Operating in tracking mode can allow the system to adjust the estimate of the DC offset to compensate for time variations of the DC offset, and to improve an initial estimate of the DC offset.

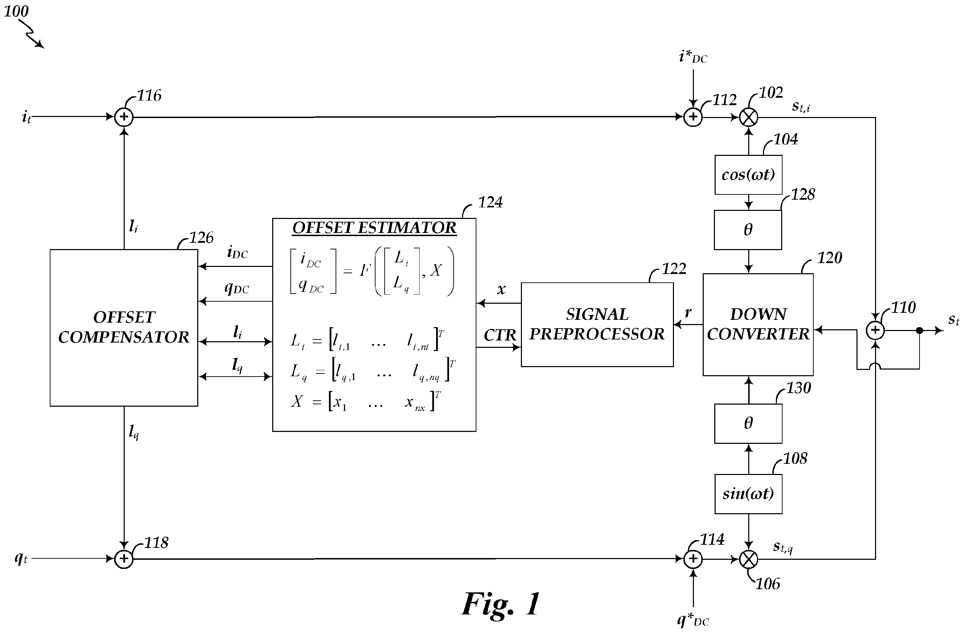

To further illustrate, Figure 1 is a schematic block diagram illustrating an upconverter offset compensation system 100 of an RF transmitter in accordance with embodiments. The upconverter offset compensation system 100 can be used with heterodyne/super-heterodyne RF transmitters, or any other RF transmitter that employs, for example, quadrature transmission, even if this quadrature operation occurs in only one stage of the RF receiver.

The upconverter offset compensation system 100 has an I path that includes an I-channel mixer 102 and an I-channel local oscillator ("LO") 104 to modulate the baseband signal $i_t$ on a carrier signal $\cos(\omega t)$. Similarly, the upcon-

verter offset compensation system 100 has a Q path that includes a Q-channel mixer 106 and a Q-channel LO 108 to modulate baseband signal $q_t$ on a carrier signal $\sin(\omega t)$. The I-channel LO 104 has a 90 degree phase shift relative to the Q-channel LO 108. It will be appreciated that the I-channel LO 104 and the Q-channel LO 108 can be part of one LO circuit. For example, in one embodiment, one of the I-channel LO 104 or the Q-channel LO 108 is implemented by generation of a 90 degree phase shift from an output signal of the other. The I-channel signal $s_{t,i}$ and the Q-channel signal $s_{t,q}$ are combined at a summing junction 110 to form the RF transmit signal $s_t$. For example, the summing junction 110 can be a summing amplifier that adds the I-channel signal $s_{t,q}$ and the Q-channel signal $s_{t,q}$ together to form the RF transmit signal $s_t$. Other applicable types of summing junctions, including analog and digital adders, will be readily determined by one of ordinary skill in the art. During communication, the transmit signal $s_t$ is transmitted through a communication channel (for example, a wired or wireless channel) to an RF receiver (not shown).

In operation, the I-channel mixer 102 and the Q-channel mixer 106 can generate unintended DC offsets. For example, the model of Figure 1 represents these DC offsets $i^*_{DC}$ and $q^*_{DC}$ as being added to the input of the I-channel mixer 104 and the Q-channel 106 mixer via model summing junctions 112,114, respectively, which merely model the offsets and do not correspond to actual circuit elements. Neglecting DC offset compensation for the moment (but which will be considered below in detail), the RF transmit signal can then be represented by the following equation:

$$t_0(t) = \mathrm{Re}\left\{\left[\left(i(t)+i^*_{DC}\right)+j*\left(q(t)+q^*_{DC}\right)\right]e^{jwt}\right\} \qquad \text{(Equation 1)}$$

In Equation 1, the baseband signals $i_t(t)$ and $q_t(t)$ represents time-varying baseband signals to be transmitted. Equation 1 illustrates the effect of the DC offset. For instance, without offset compensation, the RF transmit signal $t_0(t)$

carries the additional feed-through term $\mathrm{Re}\left\{\left[i^*_{DC}+j*q^*_{DC}\right]e^{jwt}\right\}$ which acts as a noise with respect to communication signal estimation and/or detection.

It will be appreciated that the offsets $i^*_{DC}$ and $q^*_{DC}$ shown in Figure 1 may not represent actual physical signals or inputs to the upconverter mixers 102, 106. Rather, the signals $i^*_{DC}$ and $q^*_{DC}$ represent or model the DC offset behavior of the mixers 102, 106. In the frequency domain, a DC offset manifests itself as an unmodulated carrier signal appearing at the output of the modulator (for example, an $i^*_{DC}\cos(\omega t)$ term). In the frequency domain, this LO leakage appears at the center of the modulated spectrum. DC offset can be the result of asymmetric circuit components. Additionally, DC offset can be generated by the one or both of the LOs 104, 108 electromagnetically coupling with other components of the RF transmitter, such as filters, amplifiers, and analog/digital converters, during operation.

When the transmit signal $s_t$ (for example, an RF signal or an IF signal) is subsequently downconverted by an RF receiver circuit (not shown), a DC offset can be superimposed on the baseband signal. Moreover, since various modulation schemes involve a constant envelope modulation, such as Gaussian Frequency Shift Keying (GFSK) and Frequency-Shift Keying (FSK), DC offset can adversely affect performance. Other modulation techniques, such as Phase-Shift Keying (PSK) and QPSK, for example, are also sensitive to DC offset. DC offset reduces the signal-to-noise ratio of the transmitter-receiver, and increase the number of bit errors for a given data rate. Therefore, it is desirable to attenuate DC offset from the I path and the Q path before upconverting.

Returning to Figure 1, the upconverter offset compensation system 100 includes second and third summing junctions 116, 118. The second summing junction 116 receives the baseband I-channel signal $i_t$ and the I-channel compensation signal $l_i$ and generates a first modified baseband signal (for example, a signal $i_t+l_i$) to be provided as an output. The third summing junction 118 receives the baseband Q-channel signal $i_q$ and the Q-channel compensation signal $l_q$ and generates a second modified baseband signal (for example, signal $i_q+l_q$) as output. The summing junctions 116, 118 can be implemented by, for example, summing amplifiers. Other applicable types of summing junctions, including analog and digital adders, will be readily determined by one of ordinary skill in the art.

The compensation signals can be selected to null out or attenuate the effects of the DC offsets $i^*_{DC}$ and $q^*_{DC}$. For example, the RF transmit signal $s_t$ can be represented by the following equation:

$$t_s(t) = \mathrm{Re}\left\{\left[\left(i_t(t)+i^*_{DC}+l_i\right)+j*\left(q_t(t)+q^*_{DC}+l_q\right)\right]e^{jwt}\right\} \qquad \text{(Equation 2)}$$

Equation 2 illustrates that the compensation signals are matched with the corresponding DC offset. For example, the I-channel compensation $l_i$ and the I-channel DC offset $i^*_{DC}$ are added together to form part of a first term, and the Q-channel compensation $l_q$ and the Q-channel DC offset $q^*_{DC}$ are added together to form part of a second term. In one embodiment, the I-channel compensation signal $l_i$ is based on a negative version of an estimate of the I-channel offset $i^*_{DC}$ to cancel the I-channel DC offset $i^*_{DC}$. In another embodiment, the Q-channel compensation signal $l_q$ is based on a negative version of an estimate of the Q-channel DC offset $q^*_{DC}$ to cancel the Q-channel DC offset $q^*_{DC}$.

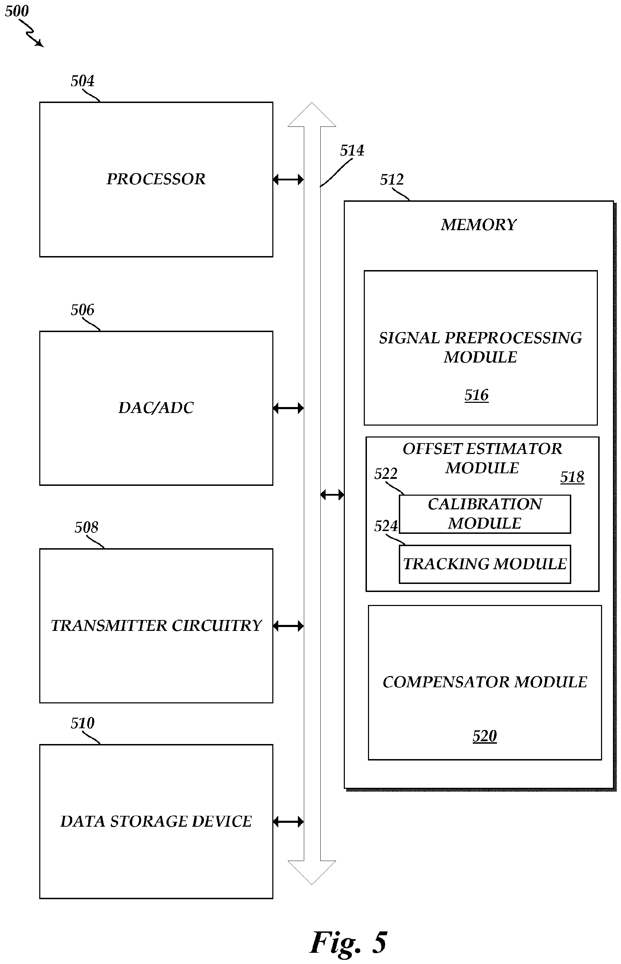

The upconverter offset compensation system 100 generates estimates $i_{DC}(t)$ and $q_{DC}(t)$ of the DC offset $i^*_{DC}$ and $q^*_{DC}$ by processing the RF transmit signal $s_t$, and generating the compensation signals $l_i$ and $l_q$ based on the generated estimates $i_{DC}(t)$ and $q_{DC}(t)$. For example, the upconverter offset compensation system 100 includes a downconverter 120, a signal preprocessor 122, and an offset estimator 124 to monitor the output of the mixers 102, 106 and to generate offset estimates $i_{DC}(t)$ and $q_{DC}(t)$ therefrom. Phase delay blocks 128, 130 have been included to model (they do not correspond to actual circuit elements) the phase difference between the carrier signal used when it was upconverted and the carrier signal used when it was downconverted. For example, after being upconverted with the carrier $\cos(\omega t)$, the I-channel transmit signal $s_{t,i}$ travels through the summing junction 110 and then to the demodulator. Because of the computational time to move along the signal path, the I-channel signal will be demodulated by the carrier signal $\cos(\omega t + \theta)$. In one embodiment, the signal preprocessor 122 and/or the offset estimator 124 is implemented by firmware instructions performed by a processor as will be described later in connection with Figure 5.

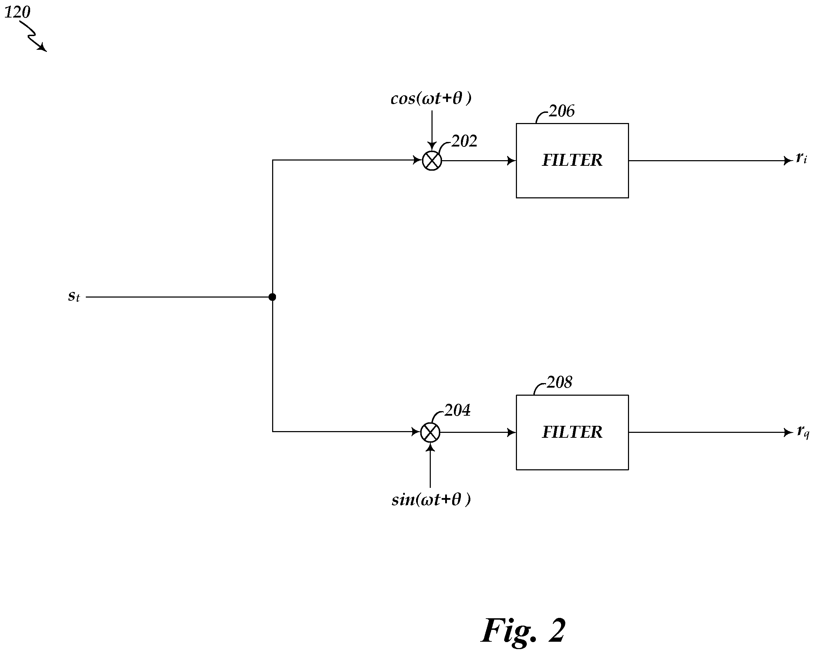

The downconverter 120 receives the RF transmit signal $s_t$ and, using the LOs 104 and 108, generates a model receive signal $r[n]$ by demodulating the RF transmit signal. The index "$n$" denotes that $r[n]$ is a digital signal, as will be explained later in connection with Figure 2. For example, an analog-to-digital ("ADC") converter (not shown) can be used to convert the output of the downconverter 120 to a digital signal. It will be appreciated, however, that the model receive signal $r[n]$ can be provided to the signal preprocessor 122 as an analog signal.

After demodulation of the downconverter 120, the model receive signal $r[n]$ can be represented by the following equation:

$$r[n] = \left[ \left( i^*_{DC} + l_i \right) + j \left( q^*_{DC} + l_q \right) \right] e^{j\theta} + v[n] \qquad \text{(Equation 3)}$$

The disturbance signal $v[n]$ represents noise and intended baseband signal of the model receive signal. The disturbance signal $v[n]$ acts as an interference signal with respect to estimation. In some embodiments, the disturbance signal $v[n]$ has zero mean. The phase $\theta$ represents the phase difference due to signal transportation lag between the mixers 102, 106 and the downconverter 120. One advantage, among others, is that some embodiments need not estimate the LO leakage and/or need not estimate the channel for phase $\theta$ tracking.

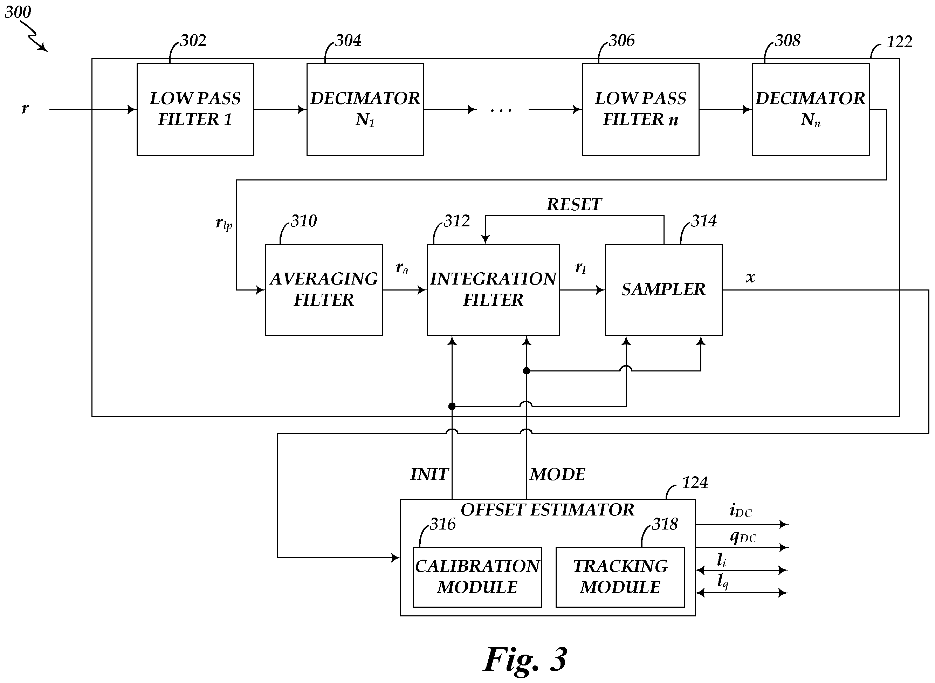

The signal preprocessor 122 receives the model receive signal $r[n]$ and generates a processed signal $x$. In one embodiment, the signal preprocessor 122 filters out or attenuates the disturbance signal $v[n]$ of the model receive signal $r[n]$, as discussed in further detail in connection with Figure 3. In the case where the signal preprocessor 122 substantially reduces the disturbance signal $v[n]$, the processed signal $x$ can be represented by the following equation:

$$x\left( l_i, l_q \right) = \left[ \left( i^*_{DC} + l_i \right) + j \left( q^*_{DC} + l_q \right) \right] e^{j\theta} \qquad \text{(Equation 4)}$$

The signal preprocessor 122 can generate a plurality of samples $x_l, ..., x_n$ of the processed signal $x$. For example, various compensation signals $(l_{i1}, l_{g1}), ... , (l_{in}, l_{qn})$ can be selected and each applied for a duration to generate the samples $x_1, ..., x_n$. If the disturbance signal $v[n]$ has been substantially attenuated, the samples $x_1, ..., x_n$ and the compensation signals $(l_{i1}, l_{q1}), ... , (l_{in}, l_{qn})$ carry information regarding the DC offset.

The offset estimator 124 receives samples of processed signal $x[n]$ as input and generates offset estimates $i_{DC}(t)$ and $q_{DC}(t)$ as outputs. In some embodiments, the offset estimator 124 receives the compensation signals $l_i$ and $l_q$ as input. In other embodiments the offset estimator retrieves values of the compensation signals $l_i$ and $l_q$. For example, some embodiments of the offset estimator 124 control the selection of the compensation signals $l_i$ and $l_q$ by outputting the values of the compensation signals. The offset estimator 124 then retrieves the compensation signal $l_i$ and $l_q$ internally. The offset estimator can also generate a control signal CTR that controls various aspects of the signal preprocessor 122 in accordance with the operation of the offset estimator 124, such as initialization and mode control. The control signal CTR will be discussed in more detail below in connection with Figure 3 (for example, the INIT signal and the MODE signal of Figure 3).

During operation, the offset estimator 124 generates the offset estimates based at least partly on at least two selected samples $x_1$ and $x_2$ of the processed signal $x$ and the corresponding values of the compensation signals $l_i$ and $l_q$. A mapping of the inputs of the offset estimator 124 to the offset estimates can be represented as:

$$\begin{bmatrix} i_{DC} \\ q_{DC} \end{bmatrix} = F\left(\begin{bmatrix} L_i \\ L_q \end{bmatrix}, X\right)$$

$$L_i = \begin{bmatrix} l_{i,1} & \dots & l_{i,ni} \end{bmatrix}^T$$
$$L_q = \begin{bmatrix} l_{q,1} & \dots & l_{q,nq} \end{bmatrix}^T \qquad \text{(Equation 5)}$$
$$X = \begin{bmatrix} x_1 & \dots & x_{nx} \end{bmatrix}^T$$

A capital letter in Equation 5 represents a vector quantity formed by collecting the corresponding samples. For example, $L_i$ denotes a collection of the corresponding samples of $I_1$. In some embodiments, the offset estimator 124 can generate offset estimates for the I-channel, the Q-channel, and/or both. Additionally offset estimator 124 can generate estimates in real-time, dynamically, and/or without user intervention. The offset estimator 124 is described in further detail later in connection with Figures 3 and 6-10.

The offset compensator 126 of the upconverter offset compensation system 100 receives values (for example, the offset estimates and/or values of the control signals) for updating the compensation signals as input and generates the compensation signals as output. In one embodiment, the offset estimator 124 directly controls the values at which the offset compensator 126 generates the compensation signals. For example, the offset compensator 126 can receive the compensation values as input from offset estimator 124. In another embodiment, the offset compensator 126 receives the estimates from the offset estimator 124, but the offset compensator 126 or an external system (not shown) selects whether the compensation signal are updated based on the received offset estimation. The offset estimator 126 may update the compensation signals periodically. Additionally or alternatively, the offset compensator 126 can provide the current values of the compensation signals to the offset estimator 124 for generation of offset estimates.

In some embodiments, the compensation signals used in offset estimation are selected based on considerations other than DC offset attenuation. For example, during a calibration mode or a tracking mode (discussed below), the offset compensator 126 can provide a sequence of compensation signals not necessarily for attenuation of the DC offset, but rather for estimation. For example, increasing the magnitudes of the compensations signals can improve estimation convergence. One specific example is when the sequence $l_{i,1}$ and $l_{i,2}$ is selected such that the difference between the two compensation signals $l_{i,1}$ and $l_{i,2}$ is large. For example, the compensation signals $l_{i,1}$ and $l_{i,2}$ can be selected such that their difference is 100% the maximum value of $l_{i,1}$ and $l_{i,2}$, without causing overflow or saturation. Accordingly, $l_{i,1}$ can be chosen to be about 50% of the maximum positive peak value, and $l_{i,2}$ can be chosen to be about 50% of the maximum negative peak value. While generating samples for estimation, the compensation signals $l_{i,l}$ and $l_{i,2}$ (or compensation signals $l_{q,1}$ and $l_{q,2}$) can be selected such that their difference is greater than a threshold. In one embodiment, the threshold can be selected as be about 0.0001% of the allowable peak value of the baseband signals $i_t$ (or $q_t$). In another example, the threshold can be selected to be greater than about 1/32 of the allowable peak value of the baseband signals $i_t$, $q_t$. In another, the predetermined threshold can be selected to be greater than about 25% of the allowable peak value the baseband signals $i_t$, $q_t$. In another, the predetermined threshold can be selected to be greater than about 50% of the allowable peak value the baseband signals $i_t$, $q_t$. In other embodiments, the compensation signals are selected in any applicable manner, with or without thresholds.

Figure 2 is a schematic block diagram illustrating a downconverter 120 of Figure 1 in accordance with one embodiment. The downconverter 120 receives the RF transmit signal $s_t$ and generates downconverted signals $r_i$ and $r_q$. The RF transmit signal $s_t$ is carried on two paths to be separately demodulated using the carrier signals from the transmitter's LO (for example, from LOs 104, 108) to generate an in-phase component at the output of the mixer 202 and a quadrature-phase component at the output of the mixer 204. The in-phase and quadrature-phase components of the downconverted transmit signal pass through the low-pass filters 206, 208 to eliminate unwanted side bands. For example, the low-pass filters 206, 208 pass the baseband frequency while rejecting the sum frequency image, resulting in a complex baseband representation of the original signal. In some embodiments, the downconverter 120 converts the RF transmit signal to an intermediate frequency (IF) signal. In one embodiment, the mixers 202, 204 are substantially calibrated so as to not substantially introduce additional DC offset or I/Q imbalance. The filters 206, 208 can be analog or digital, and can include ADCs.

Figure 3 is a schematic block diagram illustrating the preprocessor-estimator system 300 comprising the signal preprocessor 122 and the offset estimator 124 of Figure 1 in accordance with embodiments. The signal preprocessor 122 includes $n$ pairs of low-pass filters and decimators 302-308. In one embodiment, the signal preprocessor 122 includes 2 pairs of low-pass filters and decimeters. The first low-pass filter 302 has a bandwidth of about 20 MHz. A first low-pass filter 302 can reduce high-frequency noise content. The output of the first low-pass filter 302 is provided as an input to a first decimator 304 for downsampling the signal by a factor of 7. The output of the decimator 304 is provided as an input to a second low-pass filter 306, which has a bandwidth of about 0.5 MHz for attenuating the baseband signal portion. The output of the second low-pass filter 306 is provided to a second decimator 308 for downsampling by a factor of 7. Other applicable bandwidths and downsampling factors will be readily determined by one of ordinary skill in the art. Furthermore, a different number of applicable pairs of low-pass filters and decimators can be selected.

The signal preprocessor 122 can also include an averaging filter 310 and an integration filter 312. The averaging filter 310 receives the output $r_{lp}$ of the last decimator of the chain, such as the second decimator 308. The averaging filter 310 can further attenuate the disturbance signal $v[n]$, including the residual baseband signals and noises having zero mean. The integration filter 312 is configured to receive the output $r_{MA}$ of the averaging filter 310. The integration filter 312 can have a leaky integrator transfer function. A leaky integrator is a filter that approximately behaves as an integrator over short periods of time, but is asymptotically stable. The integration filter 312 can be used to build up the signal strength of $x$ over the sampling period.

The signal preprocessor 122 can also include a sampler 314 that receives the output $r_l$ of the integration filter 312 and generates samples of $x$ for the offset estimator 124. The sampler 314 can reset the integration filter 312 after each sample. The sampler 314 can select the sample rate based on the MODE signal (described below) from the offset estimator 124.

As stated, the offset estimator 124 is configured to receive the processed signal $x$ and configured to generate offset estimates $i_{dc}$ and $q_{dc}$. The processed signal can have reduced disturbance signal $v[n]$ relative to the model receive signal $r[n]$. In particular, where the disturbance signal substantially reduced, the processed signal $x$ has the follow expression:

$$x = \left[\left(i_{DC}^* + l_i\right) + j\left(q_{DC}^* + l_q\right)\right]e^{j\theta} \qquad \text{(Equation 6)}$$

As expressed in Equation 6, the processed signal $x$ is a function of the unknown DC offsets, the phase difference $\theta$, and the compensation signals. A plurality of samples $x_1, ..., x_n$ can be generated for calculating the unknown DC offsets. For example, the two measurement can be made first by selecting compensation signal $l_{q,1}$ as the Q-channel compensation signal for a first duration to generate a sample $x(l_{q,1})$, and then selecting compensation signal $l_{q,2}$ as the Q channel compensation for a second duration to generate a sample $x(l_{q,2})$:

$$x\left(l_{q,1}\right) = \left[\left(i_{DC}^* + l_{i,1}\right) + j\left(q_{DC}^* + l_{q,1}\right)\right]e^{j\theta}$$
$$x\left(l_{q,2}\right) = \left[\left(i_{DC}^* + l_{i,1}\right) + j\left(q_{DC}^* + l_{q,2}\right)\right]e^{j\theta} \qquad \text{(Equation 7)}$$

The DC offset can be solved for algebraically by performing the following manipulations and solving for the DC offsets:

$$\left|x\left(L_{iq,1}\right)\right|^2 = \left(i_{DC}^* + l_{i,1}\right)^2 + \left(q_{DC}^* + l_{q,1}\right)^2$$
$$\left|x\left(L_{iq,2}\right)\right|^2 = \left(i_{DC}^* + l_{i,1}\right)^2 + \left(q_{DC}^* + l_{q,2}\right)^2 \qquad \text{(Equation 8)}$$

$$q_{DC}^* = \frac{1}{2}\left\{\frac{\left|x\left(l_{q,1}\right)\right|^2 - \left|x\left(l_{q,2}\right)\right|^2}{\left(l_{q,1} - l_{q,2}\right)}\right\} - \left(l_{q,1} + l_{q,2}\right) \qquad \text{(Equation 9)}$$

$$i_{DC}^* = \pm\sqrt{\left|x\left(L_{iq,1}\right)\right|^2 - \left(q_{offset} + L_{iq,1}\right)^2} - L_{ic} \qquad \text{(Equation 10)}$$

Equations 9 and then 10 can be used calculate the DC offsets because the right-hand sides of Equations 9 and 10 can be known, measurable, or computable. The sign ambiguity of the I-channel offset $i^*_{DC}$ can be overcome by, for example, selecting one value and switching values if performance is unsatisfactory. The initial selection can be determined based on past selections.

In one embodiment, three samples of the processed signal *x* are taken to overcome the sign ambiguity of Equation 10 related to the I-channel offset $i*_{DC}$. One example selection of the compensation signals for generating samples can be made as follows:

$$x_1 = \left[\left(i^*_{DC} + l_{i,1}\right) + j\left(q^*_{DC} + l_{q,1}\right)\right]e^{j\theta}$$
$$x_2 = \left[\left(i^*_{DC} + l_{i,1}\right) + j\left(q^*_{DC} + l_{q,2}\right)\right]e^{j\theta} \qquad \text{(Equation 11)}$$
$$x_3 = \left[\left(i^*_{DC} + l_{i,2}\right) + j\left(q^*_{DC} + l_{q,2}\right)\right]e^{j\theta}$$

After generating samples $x_1$, $x_2$, and $x_3$ from the output of the signal preprocessor 122, the DC offsets can be calculated by using Equation 11 and solving for the DC offsets:

$$q_{offset} = \frac{1}{2}\left\{\frac{|x_1|^2 - |x_2|^2}{\left(l_{q,1} - l_{q,2}\right)}\right\} - \left(l_{q,1} + l_{q,2}\right)$$

$$i_{offset} = \frac{1}{2}\left\{\frac{|x_2|^2 - |x_3|^2}{\left(l_{i,1} - l_{i,2}\right)}\right\} - \left(l_{i,1} + l_{i,1}\right)$$

(Equation 12)

In Equation 12, there is no sign ambiguity with respect to either DC offsets. In both Equations 9 and 10, as well as equation 12, the offset estimates $i_{dc}$ and $q_{dc}$ can be made based on calculations involving the measured output (for example, the transmit signal or the processed signal *x*) and the corresponding compensation signals. In some embodiments, considering Equation 12, generating the offset estimate is based at least partly on a first comparison between squared magnitudes of the first and second samples and based at least partly on a second comparison between the first and second values of the corresponding compensation signal.

The offset estimator 124 includes a calibration module 316 and a tracking module 318 for operating in a calibration mode and in a tracking mode. The way in which the offset estimator 124 generates offset estimates can vary depending on the active mode. For example, calibration mode can be entered during an initialization process. Calibration mode can use equations 9 and/or 10 to calculate the offset estimation. In another embodiment, the calibration mode can use Equation 12 to generate the offset estimation.

In tracking mode, the offset estimator 124 can make adjustments to the offset estimates $i_{dc}$ and $q_{dc}$ over time. Adjustments can be desirable, for example, for improving the initial estimates generated during a calibration mode. Additionally or alternatively, tracking mode can be used to track variations in the DC offset over time. The DC offset can drift over time due to changing operating conditions (temperature, wear, degradation, etc.).

In tracking mode, the system uses an iterative algorithm involving three or more samples the processed signal generated by the signal preprocessing module 516 and values of the compensation signals $l_i$ and $l_q$ during the corresponding sampling period. For example, three or more measures of the following:

$$x(l_{q,n}, l_{i,m}) = v(l_{q,n}, l_{i,m}) + \left[\left(i_{DC} + \Delta i_{DC} + l_{i,m}\right) + j\left(q_{DC} + \Delta q_{offset} + l_{q,m}\right)\right]e^{j(\theta + \Delta\theta)} \text{(Equation 13)}$$

In Equation 13, the incremental parameters $\Delta i_{DC}$, $\Delta q_{DC}$, $\Delta\theta$ represent deviations from the offset estimates. In some embodiments, the incremental parameters are unknown and not measurable. These incremental parameters can be non-zero due to inaccuracies in the initial estimation and/or due to time variations in the DC offset. Equation 13 can be approximated as follows:

(Equation 14)

$$x(l_{q,n}, l_{i,m})e^{-j\theta} = e^{-j\theta}v(l_{q,n}, l_{i,m}) + \left[\left(i^*_{DC} + \Delta i_{DC} + l_{i,m}\right) + j\left(q^*_{DC} + \Delta q_{offset} + l_{q,m}\right)\right]\left(1 + j\Delta\theta\right)$$

To simplify notation, the following definition is used herein:

$$\lambda_m + j\eta_m \equiv dc(L_{i,m}, L_{q,m})e^{-j\theta} \qquad \text{(Equation 15)}$$

In some embodiments, a least-squares based approach can be used to estimate the incremental parameters $\Delta i_{DC}$, $\Delta q_{DC}$, and $\Delta \theta$. For example, the following cost function can be used:

$$c\left(\Delta i_{offset}, \Delta q_{offset}, \Delta \theta\right) =$$
$$\sum_m \left(i_{offset} + \Delta i_{offset} + L_{i,m} - \Delta \theta \left(q_{offset} + \Delta q_{offset} + L_{q,m}\right) - \lambda_m\right)^2 +$$
$$\sum_n \left(q_{offset} + \Delta q_{offset} + L_{q,m} + \Delta \theta \left(i_{offset} + \Delta i_{offset} + L_{i,m}\right) - \eta_m\right)^2 \qquad \text{(Equation 16)}$$

The cost function of Equation 16 can be solved by using a variety of numerical techniques. For example, a gradient based method follows:

$$\Delta i_{DC}^k = \Delta i_{DC}^{k-1} - \alpha_i \left. \frac{\partial c\left(\Delta i_{DC}, \Delta q_{DC}, \Delta \theta\right)}{\partial \Delta i_{DC}} \right|_{\Delta i_{DC}^{k-1}, \Delta q_{DC}^{k-1}, \Delta \theta^{k-1}}$$

$$\Delta q_{DC}^k = \Delta q_{DC}^{k-1} - \alpha_q \left. \frac{\partial c\left(\Delta i_{DC}, \Delta q_{DC}, \Delta \theta\right)}{\partial \Delta q_{DC}} \right|_{\Delta i_{DC}^{k-1}, \Delta q_{DC}^{k-1}, \Delta \theta^{k-1}} \qquad \text{(Equation 17)}$$

$$\Delta \theta^k = \Delta \theta^{k-1} - \alpha_\theta \left. \frac{\partial c\left(\Delta i_{DC}, \Delta q_{DC}, \Delta \theta\right)}{\partial \Delta \theta} \right|_{\Delta i_{DC}^{k-1}, \Delta q_{DC}^{k-1}, \Delta \theta^{k-1}}$$

Equation 17 can be iterated a number of times. For example, the offset estimator 124 can iterate computing Equation 17 until $c(\Delta i_{DC}, \Delta i_{DC}, \Delta \theta)$ is -100dB relative to full scale (for example, 0.001% of the maximum value of $r[n]$). The gradients used in Equation 17 can be given by:

$$\frac{\partial c\left(\Delta i_{offset}, \Delta q_{offset}, \Delta \theta\right)}{\partial \Delta i_{offset}} = 2\sum_m \left(i_{offset} + \Delta i_{offset} + L_{i,m} - \Delta \theta \left(q_{offset} + \Delta q_{offset} + L_{q,m}\right) - \lambda_m\right) +$$
$$2\Delta \theta \sum_n \left(q_{offset} + \Delta q_{offset} + L_{q,m} + \Delta \theta \left(i_{offset} + \Delta i_{offset} + L_{i,m}\right) - \eta_m\right) \qquad \text{(Equation 18)}$$

$$\frac{\partial c\left(\Delta i_{DC}, \Delta q_{DC}, \Delta \theta\right)}{\partial \Delta q_{DC}} = -2\Delta \theta \sum_m \left(i_{DC} + \Delta i_{DC} + l_{i,m} - \Delta \theta \left(q_{DC} + \Delta q_{DC} + l_{q,m}\right) - \lambda_m\right) +$$
$$2\sum_n \left(q_{DC} + \Delta q_{DC} + l_{q,n} + \Delta \theta \left(i_{DC} + \Delta i_{DC} + l_{i,n}\right) - \eta_n\right) \qquad \text{(Equation 19)}$$

$$\frac{\partial c\left(\Delta i_{DC}, \Delta q_{DC}, \Delta \theta\right)}{\partial \Delta \theta} =$$
$$-\sum_m \left(q_{DC} + \Delta q_{DC} + l_{q,m}\right)\left(i_{DC} + \Delta i_{DC} + l_{i,m} - \Delta \theta \left(q_{DC} + \Delta q_{DC} + l_{q,m}\right) - \lambda_m\right) +$$
$$\sum_n \left(i_{DC} + \Delta i_{DC} + l_{i,n}\right)\left(q_{DC} + \Delta q_{DC} + l_{q,n} + \Delta \theta \left(i_{DC} + \Delta i_{DC} + l_{i,n}\right) - \eta_n\right)$$
$$\text{(Equation 20)}$$

In some embodiments, tracking mode can be initiated periodically to maintain acceptable offset compensation. In other embodiments, tracking mode can be initiated by monitoring transmission performance (for example, based on error rates or constellation offsets determined from the model receive signal $r[n]$).

In one embodiment, the offset estimator can estimate the DC offset during data transmission. For example, the offset estimator 124 can perform tracking mode (for example, governed by Equations 17-20) during data transmission. In one advantage is that data communication and service need not be interrupted.

The offset estimator 124 can provide the signal preprocessor 122 two control signals, the INIT signal and the MODE signal. The INIT signal can be used to set the initial state of the integration filter 312 and the sampler 314. The MODE signal can configure the integration filter 312 and sampler 314 to operate in calibration mode or in tracking mode. The integration filter and sampler can adjust a number of parameters, including sample rate, bandwidth, forgetting factor, order of sampling, and the like

In some embodiments, the offset estimator 124 is configured to select the values of the compensation signals for the offset compensator 126. For example, the offset estimator 124 can select the compensation signals during estimation to ensure proper measurement can be made. Additionally or alternatively, the offset estimator 124 can select the compensation signals upon detection of a successful attempt in estimating the DC offset. In another embodiment, the offset estimator 124 is configured to receive or retrieve values of the compensation signal. The offset estimator 124 can use the values of the compensation signals to calculate offset estimates.

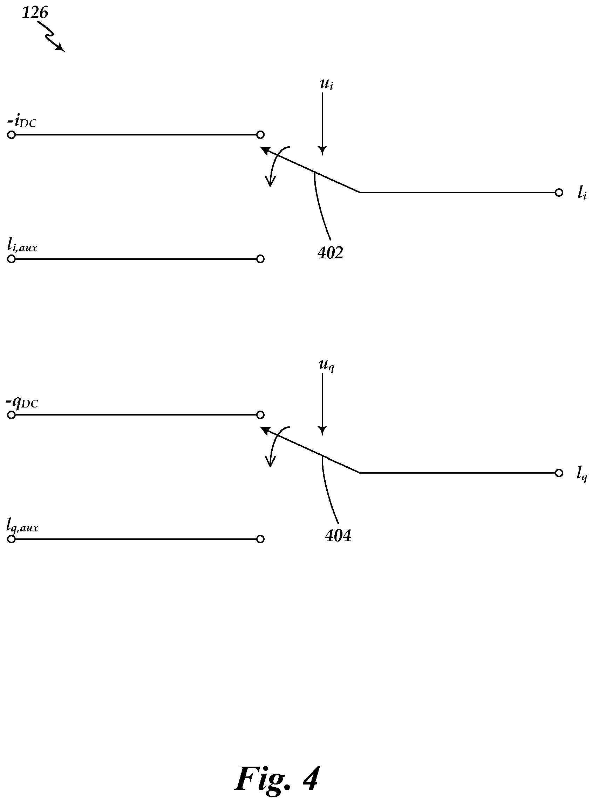

Figure 4 is a schematic diagram illustrating the offset compensator 126 of Figure 1 in accordance with an embodiment. The offset compensator 126 includes switches 402, 404 to select the values of the offset compensation signals $I_i$ and $I_q$. For example, the switch 402 can select either the negative value of the offset estimate $i_{DC}$ or an auxiliary compensation signal $I_{i,aux}$ to add to the I path of the upconverter offset compensation system 100 of Figure 1. Similarly, the switch 404 can select either the negative value of the offset estimate $q_{DC}$ or an auxiliary compensation signal $I_{q,aux}$ to add to the Q path of the upconverter offset compensation system 100 of Figure 1. The auxiliary compensation signals $I_{i,aux}$ and $I_{i,aux}$ can be selected for considerations other than direct cancelation of DC offset. For example, in some embodiments the auxiliary compensation signals $I_{i,aux}$ and $I_{i,aux}$ are designed to produce transmit signals $s_t$ that have characteristics advantageous for estimation. In one embodiment, the auxiliary compensation signals $I_{i,aux}$ and $I_{i,aux}$ are selected during calibration mode to have large magnitudes to improve the sound to noise ratio.

The switching control signals $u_i$ and $u_q$ open and close the switches 402 and 404. The switching signals $u_i$ and $u_q$ can be generated by the offset estimator 124 of Figure 1 or by an external control logic.

Now turning to Figure 5, a system diagram is shown illustrating a processor-based system 500 for implementing the signal preprocessor 122 and the offset estimator 124 of Figures 1 and 3 in accordance with embodiments. The processor-based system 500 includes a processor 504, DAC/ADC 506, transmitter circuitry 508, data storage device 510, and the memory 512 communicatively coupled, directly or indirectly, by a communication channel, such as a bus 514. Furthermore, the memory 512 can include a signal preprocessing module 516, offset estimator module 518, and compensator module 520. Examples of the processor-based system 500 include any applicable electronic device, such as a mobile computing device, cellular phone, general purpose computer, and the like.

The processor 504 includes circuitry, such as a microprocessor or microcontroller, configured to execute instructions from the memory 512 and to control and operate the DAC/ADC 506, the transmitter circuitry 508, the data storage device 510, the memory 512, and the bus 514. In particular, the processor 504 can be a general purpose single- or multichip microprocessor (e.g., an ARM), a special purpose microprocessor (e.g., a digital signal processor (DSP)), a microcontroller, a programmable gate array, application specific integrated circuit (ASIC), etc. Although just a single processor is shown in the processor-based system 500, in an alternative configuration, a combination of processors (e.g., an ARM and DSP) could be used.

The DAC/ADC 506 is configured to convert digital signals to analog signals and to convert analog signals to digital signals, as controlled by the processor 504 executing specific instructions from the memory 512. For example, DAC/ADC 506 can convert the analog RF transmit signal to a digital signal for processing by the signal preprocessing module 516 and/or the offset estimator module 518.

The transmitter circuitry 508 includes electronics and hardware for RF transmission, such as upconverter mixers 102, 106 and the downconverter 120 of Figure 1.

The data storage device 510 and the memory 512 include mechanisms configured to store information by chemical, magnetic, electrical, optical, or the like means. For instance, the data storage device 510 and the memory 512 can each be a non-volatile memory device, such as flash memory or a hard-disk drive, or a volatile memory device, such as dynamic-random access memory (DRAM) or static random-access memory (SRAM). In some embodiments, the processor 504 can access the content source by accessing a content-source database of the data storage device 510.

Within the memory 512 is the signal preprocessing module 516 that includes instructions that configure the processor 504 to filter, decimate, average, integrate, and sample the model receive signal $r[n]$. For example, the signal preprocessing module 516 can contain instructions that implement the signal preprocessor 122 of Figure 1 and/or the signal preprocessor 122 of Figure 3.

The offset estimator module 518, being stored in the memory 512, includes instructions that configure the processor 504 to process the processed signals $x$ of the model receive signal $r[n]$ and the corresponding values of the compensation signal $I_i$ and $I_q$ to generate offset estimates $i_{DC}$ and $q_{DC}$.

The offset estimator module 518 has a calibration module 522 and a tracking module 524 for providing two modes of estimations. The calibration module can be executed, for example, initially when there are no initial DC offset estimates. The calibration module 522 configures the processor-based system 500 to select two or more compensation signals for each channel of the transmit signal. Each of the selected compensation signals are applied at least for a predetermined period of time and the resulting processed signals are collected. An estimate of the DC offset calibration can be generated, for example, by performing a calculation involving the collected samples and the values of the selected compensation signals. Operating in calibration mode can rapidly provide initial estimates that are sufficiently accurate for RF transmission.

The tracking module 524 configures the processor-based system 500 to operate in a tracking mode for making adjustments to the DC offset estimates $i_{dc}$ and $q_{dc}$ over time. Adjustments can be desirable, for example, for improving upon the initial estimates generated during a calibration mode. Additionally or alternatively, tracking mode can be used to track variations in the DC offset over time. The DC offset can drift over time due to changing operating conditions (temperature, electrical wear, degradation, etc.). In the tracking mode, the offset estimator module uses an iterative algorithm involving two or more samples the processed signal generated by the signal preprocessing module 516 and values of the compensation signals $I_1$ and $I_q$ during the corresponding sampling period. The values of the compensation signals $I_1$ and $I_q$ can be retrieved from the compensator module 520, or retrieved internally from within the offset estimator module 518 if the offset estimator module 518 controls the selection of the compensation signals $I_i$ and $I_q$. An adjustment calculation is used to update the DC offset estimates, the calculation involving selecting two or more compensation signals for each channel of the transmit signal.

Within the memory 512 is the compensator module 520 that includes instructions that configure the processor 504 to generate the compensation signals $I_i$ and $I_q$. For example, the instructions of the compensator module 520 can configure the processor 504 to receive DC offset estimates $i_{dc}$ and $q_{dc}$ and to generate the compensations signals based on the received estimates (for example, $I_i = -i_{DC}$). In one embodiment, the instructions of the compensator module 520 can configure the processor 504 to generate the compensation signals $I_i$ and $I_q$ for improving estimation accuracy (for example, by selecting a large compensation signal while operating in the calibration mode).

In one embodiment during operation, the processor 504 executes instructions from the memory 512 to receive a model receive signal $r[n]$ generated by the DAC/ADC 506. For example, the output $r[n]$ of the downconverter 120 of Figure 1 can be generated digitally with the DAC/ADC 506. Having received the model receive signal $r[n]$, the processor 504 executes instructions from the signal preprocessing module 516 to generate processed signal $x$. For example, the signal preprocessing module 516 can implement one or more of the low-pass filters/decimators 302-308, the averaging filter 310, the integration filter 312, and/or the sampler 314 of Figure 3. Once the processed signal $x$ has been generated, the processor 504 can then execute instructions from the offset estimator module 518 in one of two mode-either calibration mode or the tracking mode-to generate the offset estimation. The generated estimates, in turn, can be used to generate the offset compensations signals according to the instruction of the compensator module 520. For example, the DAC/ADC 506 can generate the analog versions of the offset compensation signals.

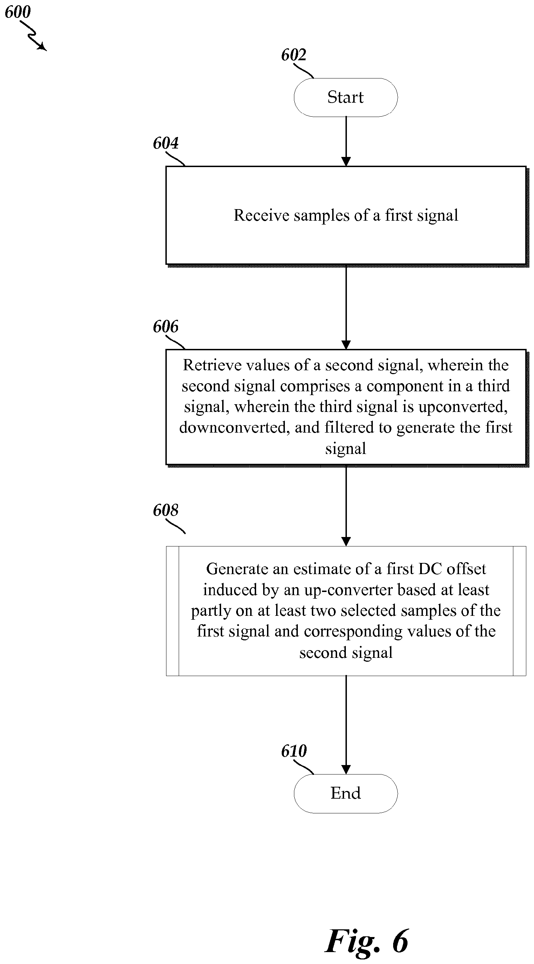

Figures 6-8 and 10 show various flow diagrams of methods of DC offset estimation and/or compensation according to embodiments. The methods can be implemented as a software module or collection of modules residing with the non-transitory computer storage, such as RAM, ROM, a hard disk drive, or the like. One or more processors of the computing device can execute the software module.

Figure 6 is a flow diagram illustrating a method 600 for estimating a DC offset induced by an upconverter mixer in accordance with yet another embodiment. The method starts at block 602 and proceeds to block 604 for receiving samples of a first signal. Receiving can include receiving a signal, or receiving or retrieving the sample from memory. For example, the offset estimator 124 of Figure 1 receives samples of the processed signal $x$ generated by the signal preprocessor 122. In one embodiment, the processor 504 of Figure 5 executes instructions from the signal preprocessing module 516 and/or the offset estimator module 518 that configures the processor 504 to transfer samples of the processed signal $x$ to the offset estimator module 518.

After receiving samples of the first signal, the method 600 continues to block 606 for retrieving values of a second signal, wherein the second signal comprises a component in a third signal, wherein the third signal is upconverted, downconverted, and filtered to generate the first signal. For example, the offset estimator 124 of Figure 1 retrieves values of the I-channel compensation signal $I_i$. The I-channel compensation signal $I_i$ is upconverted, downconverted, and filtered to generate samples of the processed signal x. While block 604 has been described as being executed prior to block 606, it will be appreciated that blocks 604 and 606 and be performed in any applicable order relative to each other.

Once samples of the first signal have been received and the values of the second signal have been retrieved, the method 600 continues to process 608 for generating the offset estimate of a first DC offset induced by an upconverter based at least partly on at least two selected samples of the first signal and corresponding values of the second signal. For example, the offset estimator 124 of Figure 1 can generate estimates in either the calibration mode or the tracking mode. Furthermore, the offset estimator 124 can generate the estimate of the first offset based on a calculation, such as Equations 9, 10, 12, and/or 17-20. Once complete, the method 600 ends at block 610.

The method 600, as a whole or in any combination of its blocks, can be performed in real-time, in the background, and/or without user interventions, by one or more processors, such as for example the processor-based system 500 of Figure 5.

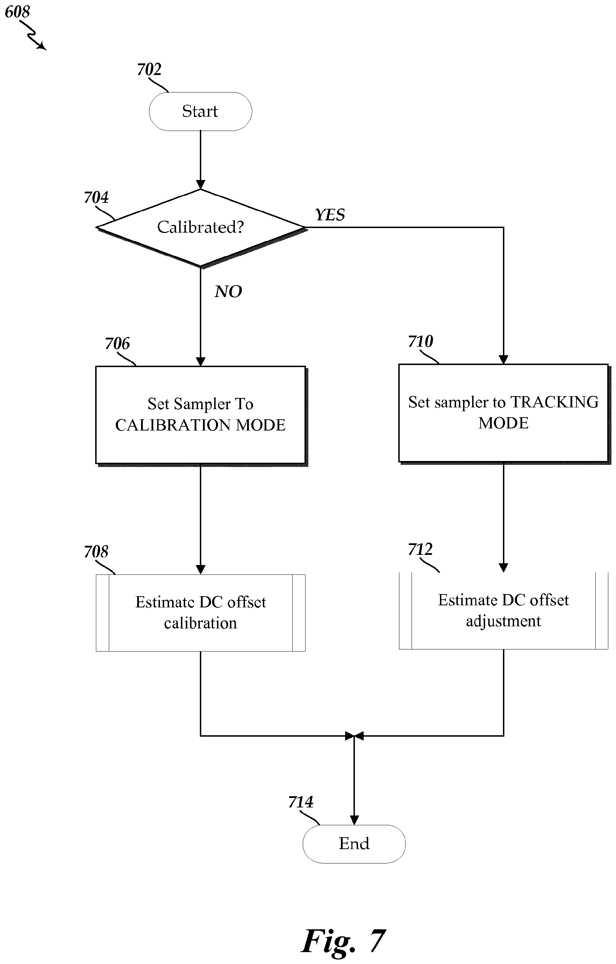

Figure 7 is a flow diagram illustrating the process 608 for generating an estimate from samples of a filtered model receive signal (for example, the processed signal *x*) in accordance with embodiments. The process start at block 702 and moves to decision block 704 to determine whether the offset estimator 124 is calibrated. If the offset estimator 124 is not calibrated, then the process 608 proceeds to block 706 to set the operation mode to CALIBRATION MODE. For example, the offset estimator 124 shown in Figure 3 signals to the integration filter 312 and the sampler 314 that the offset estimator 124 is operating in CALIBRATION MODE. In some embodiments, the integration filter 213 and the sampler 314 adjust one or more of their parameters, such as sample time, filter gains, initial conditions, sample selections, and the like, based on being in CALIBRATION MODE.

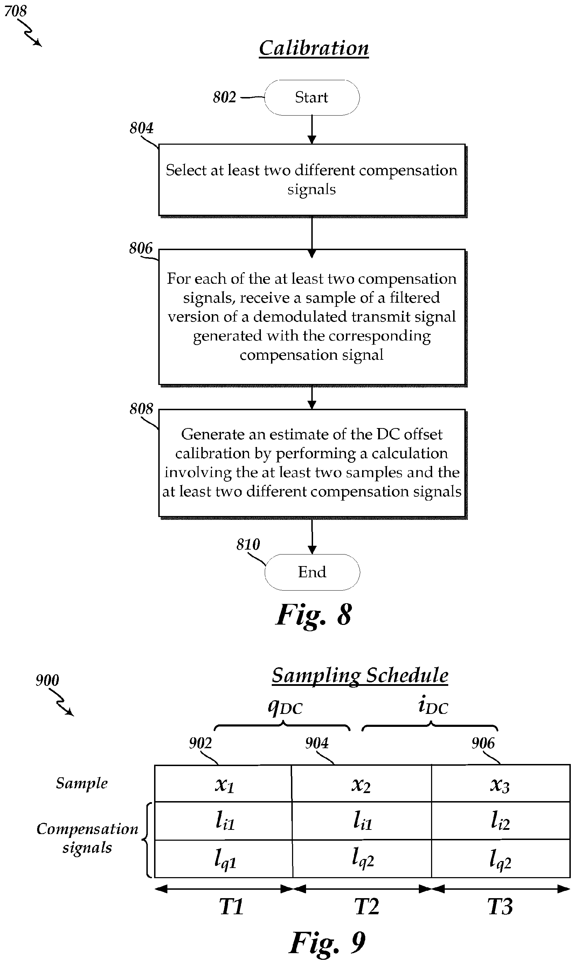

After the signal preprocessor 122 is configured to operate in CALIBRATION MODE, the process 608 moves to process 708 to generate a DC offset estimate for calibration. The process 708 is described in further detail in connection with Figure 8. After calibration is complete, the process 608 ends at block 714.

Returning to decision block 704, if the offset estimator 124 is calibrated, then the process 608 proceeds to block 710 to set the operation mode to TRACKING MODE. For example, the offset estimator 124 shown in Figure 3 signals to the integration filter 312 and the sampler 314 that the offset estimator 124 is operating in TRACKING MODE. In some embodiments, the integration filter 213 and the sampler 314 adjusts one or more of their parameters, such as sample time, filter gains, initial conditions, sample selections, and the like. For example, in some embodiments, the TRACKING MODE operates with smaller compensation signals (less energy, magnitude, etc.) and shorter sampling periods than it does in CALIBRATION MODE.

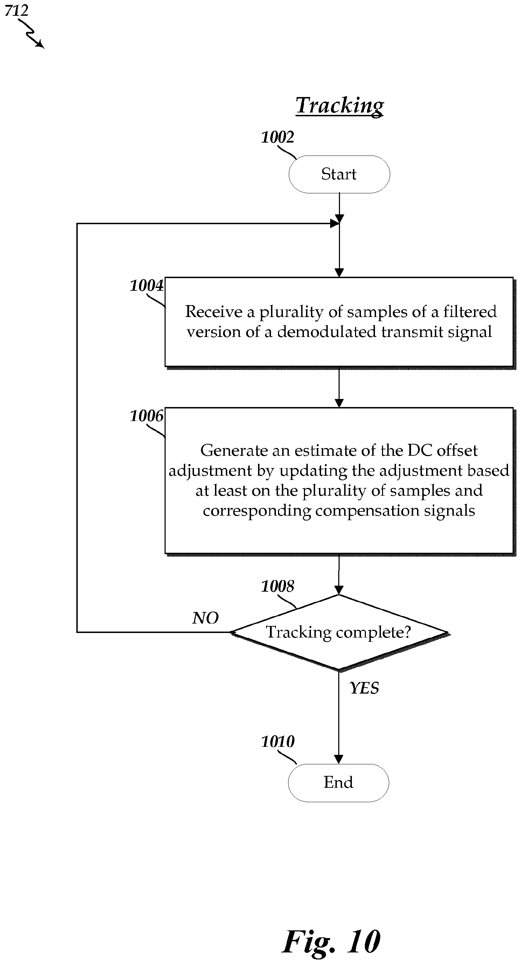

After the signal preprocessor 122 is configured to operate in TRACKING MODE, the process 608 moves to process 712 to generate a DC offset estimate for tracking. The process 712 is described in further detail in connection with Figure 10. After tracking is complete, the process 608 ends at block 714.

Figure 8 is a flow diagram illustrating a process 708 for estimating offset calibration during a calibration mode in accordance with embodiments. The process 708 starts at block 802 and moves to block 804 for selecting at least two different offset compensation signals. For example, a compensation signal can be applied during a first window, and then the compensation signal can change to a different value during a second time window, wherein samples $x_1$ and $x_2$ of the processed signal *x* are generated during the corresponding time window. In some embodiments, the processor 504 selects the compensation signals. For example, the compensation signals can be particularly adapted for estimation during a calibration mode. At least two of the compensation signals are different.

After the compensation signals have been selected, the process 708 proceeds to block 806 for receiving a sample of a filtered version of a demodulated transmit signal generated with the corresponding compensation signal. For example, each of the at least two compensation signals are sequentially applied to a transmit channel. The resulting transmit signal is downconverted, preprocessed, and sampled. Further details are discussed below in connection with Figure 9.

At block 808 the process 608 generates an estimate of the DC offset calibration by performing a calculation involving the at least two samples and the at least two different compensation signals. For example, the offset estimator 124 can perform the calculation of Equations 9, 10 and/or 12. After calibration, the process 708 terminates at block 810.

Figure 9 is a diagram illustrating a sampling schedule 900 in accordance with one embodiment. Even though the I-channel offset requires at least two samples (varying $I_i$ from $I_{i1}$ to $I_{i2}$ while $I_q$ is constant), and the Q-channel offset requires two samples (varying $I_q$ from $I_{q1}$ to $I_{q2}$ while $I_i$ is constant), the schedule shown in Figure 9 illustrates a way in which both offset estimates $i_{dc}$ and $q_{dc}$ can be generated with three sample. Column 902 shows the selection of the of the compensation signals $I_{i1}$ and $I_{q1}$ to generate $x_1$ during time window T1. During time window T2 (column 904), the Q-channel compensation signal is changed to a new value (from $I_{q1}$ to $I_{q2}$), whereas the I-channel remains at the same value of Ii1. During the third time window (column 906), the I-channel compensation signal is changed to a new value (from $I_{i1}$ to $I_{i2}$), whereas the Q-channel remains at the same value of $I_{q2}$.

Figure 10 is a flow diagram illustrating a process 712 for estimating offset adjustment during a tracking mode in accordance with embodiments. The process 712 starts at block 1002 and proceeds to block 1004 for receiving a plurality of samples of a filtered version of a demodulated transmit signal. For example, the signal preprocessor 122 receives the model receive signal *r[n]* and generates a processed signal *x*. The processed signal *x* is provided to the offset estimator 124.

At block 1006 the process 712 generate an estimate of the DC offset adjustment by updating the adjustment based at least on the plurality of samples and corresponding compensation signals. For example, the offset estimator 124 can generate offset estimates according to Equations 17-20. After adjusting or updating the offset estimation, the process 712 proceeds to decision block 1008 to determine whether tracking is complete. If tracking is complete, then the process terminates at block 1010. Otherwise, the process 712 iterates on blocks 1004 and 1006 until tracking is complete. For example, the process 712 can be performed by the offset estimator 124 as described above in connection with Equations 17-20.

# EP 2 779 553 B1

Applications

Devices employing the above described schemes can be implemented into various electronic devices. Examples of the electronic devices can include, but are not limited to, consumer electronic products, parts of the consumer electronic products, electronic test equipment, etc. Examples of the electronic devices can also include memory chips, memory modules, circuits of optical networks or other communication networks, and disk driver circuits. The consumer electronic products can include, but are not limited to, a mobile phone, base stations, communication modems, a telephone, a television, a computer monitor, a computer, a hand-held computer, a personal digital assistant (PDA), a microwave, a refrigerator, an automobile, a stereo system, a cassette recorder or player, a DVD player, a CD player, a VCR, an MP3 player, a radio, a camcorder, a camera, a digital camera, a portable memory chip, a washer, a dryer, a washer/dryer, a copier, a facsimile machine, a scanner, a multi-functional peripheral device, a wrist watch, a clock, etc. Further, the electronic device can include unfinished products.

Although this invention has been described in terms of certain embodiments, other embodiments that are apparent to those of ordinary skill in the art, including embodiments that do not provide all of the features and advantages set forth herein, are also within the scope of this invention. Moreover, the various embodiments described above can be combined to provide further embodiments. In addition, certain features shown in the context of one embodiment can be incorporated into other embodiments as well. Accordingly, the scope of the present invention is defined only by reference to the appended claims.

The technology is operational with numerous other general purpose or special purpose computing system environments or configurations. Examples of well-known computing systems, environments, and/or configurations that can be suitable for use with the invention include, but are not limited to, personal computers, server computers, hand-held or laptop devices, multiprocessor systems, processor-based systems, programmable consumer electronics, network PCs, minicomputers, mainframe computers, distributed computing environments that include any of the above systems or devices, and the like.

As used herein, instructions refer to computer-implemented steps for processing information in the system. Instructions can be implemented in software, firmware or hardware and include any type of programmed step undertaken by components of the system.

The system is comprised of various modules as discussed in detail. As can be appreciated by one of ordinary skill in the art, each of the modules comprises various subroutines, procedures, definitional statements, and macros. Each of the modules are typically separately compiled and linked into a single executable program. Therefore, the description of each of the modules is used for convenience to describe the functionality of example systems. Thus, the processes that are undergone by each of the modules can be arbitrarily redistributed to one of the other modules, combined together in a single module, or made available in, for example, a shareable dynamic link library.

The system can be written in any conventional programming language such as C#, C, C++, BASIC, Pascal, or Java, and run under a conventional operating system. C#, C, C++, BASIC, Pascal, Java, and FORTRAN are industry standard programming languages for which many commercial compilers can be used to create executable code. The system can also be written using interpreted languages such as Perl, Python, or Ruby.

Those of skill will further appreciate that the various illustrative logical blocks, modules, circuits, and algorithm steps described in connection with the embodiments disclosed herein can be implemented as electronic hardware, computer software, or combinations of both. To clearly illustrate this interchangeability of hardware and software, various illustrative components, blocks, modules, circuits, and steps have been described above generally in terms of their functionality. Whether such functionality is implemented as hardware or software depends upon the particular application and design constraints imposed on the overall system. Skilled artisans can implement the described functionality in varying ways for each particular application, but such implementation decisions should not be interpreted as causing a departure from the scope of the present disclosure.

The various illustrative logical blocks, modules, and circuits described in connection with the embodiments disclosed herein can be implemented or performed with a general purpose processor, a digital signal processor (DSP), an application specific integrated circuit (ASIC), a field programmable gate array (FPGA) or other programmable logic device, discrete gate or transistor logic, discrete hardware components, or any combination thereof designed to perform the functions described herein. A general purpose processor can be a microprocessor, but in the alternative, the processor can be any conventional processor, controller, microcontroller, or state machine. A processor can also be implemented as a combination of computing devices, e.g., a combination of a DSP and a microprocessor, a plurality of microprocessors, one or more microprocessors in conjunction with a DSP core, or any other such configuration.

In one or more example embodiments, the functions and methods described can be implemented in hardware, software, or firmware executed on a processor, or any combination thereof. If implemented in software, the functions can be stored on or transmitted over as one or more instructions or code on a computer-readable medium. Computer-readable media include both computer storage media and communication media including any medium that facilitates transfer of a computer program from one place to another. A storage medium can be any available media that can be accessed by a computer. By way of example, and not limitation, such computer-readable media can comprise RAM, ROM, EEPROM, CD-ROM or other optical disk storage, magnetic disk storage or other magnetic storage devices, or any other medium that can be used to carry or store desired program code in the form of instructions or data structures and that can be accessed by a computer. In addition, any connection is properly termed a computer-readable medium. For example, if the software is transmitted from a website, server, or other remote source using a coaxial cable, fiber optic cable, twisted pair, digital subscriber line (DSL), or wireless technologies such as infrared, radio, and microwave, then the coaxial cable, fiber optic cable, twisted pair, DSL, or wireless technologies such as infrared, radio, and microwave are included in the definition of medium. Disk and disc, as used herein, includes compact disc (CD), laser disc, optical disc, digital versatile disc (DVD), floppy disk, and Blu-ray disc where disks usually reproduce data magnetically, while discs reproduce data optically with lasers. Combinations of the above should also be included within the scope of computer-readable media.

The foregoing description details certain embodiments of the systems, devices, and methods disclosed herein. It will be appreciated, however, that no matter how detailed the foregoing appears in text, the systems, devices, and methods can be practiced in many ways. As is also stated above, it should be noted that the use of particular terminology when describing certain features or aspects of the invention should not be taken to imply that the terminology is being re-defined herein to be restricted to including any specific characteristics of the features or aspects of the technology with which that terminology is associated.

It will be appreciated by those skilled in the art that various modifications and changes can be made without departing from the scope of the described technology. Such modifications and changes are intended to fall within the scope of the embodiments. It will also be appreciated by those of skill in the art that parts included in one embodiment are interchangeable with other embodiments; one or more parts from a depicted embodiment can be included with other depicted embodiments in any combination. For example, any of the various components described herein and/or depicted in the Figures can be combined, interchanged, or excluded from other embodiments.

With respect to the use of substantially any plural and/or singular terms herein, those having skill in the art can translate from the plural to the singular and/or from the singular to the plural as is appropriate to the context and/or application. The various singular/plural permutations can be expressly set forth herein for sake of clarity.

It will be understood by those within the art that, in general, terms used herein are generally intended as "open" terms (e.g., the term "including" should be interpreted as "including but not limited to," the term "having" should be interpreted as "having at least," the term "includes" should be interpreted as "includes but is not limited to," etc.). It will be further understood by those within the art that if a specific number of an introduced claim recitation is intended, such an intent will be explicitly recited in the claim, and in the absence of such recitation no such intent is present. For example, as an aid to understanding, the following appended claims can contain usage of the introductory phrases "at least one" and "one or more" to introduce claim recitations. However, the use of such phrases should not be construed to imply that the introduction of a claim recitation by the indefinite articles "a" or "an" limits any particular claim containing such introduced claim recitation to embodiments containing only one such recitation, even when the same claim includes the introductory phrases "one or more" or "at least one" and indefinite articles such as "a" or "an" (e.g., "a" and/or "an" should typically be interpreted to mean "at least one" or "one or more"); the same holds true for the use of definite articles used to introduce claim recitations. In addition, even if a specific number of an introduced claim recitation *is* explicitly recited, those skilled in the art will recognize that such recitation should typically be interpreted to mean *at least* the recited number (e.g., the bare recitation of "two recitations," without other modifiers, typically means *at least* two recitations, or *two or more* recitations). Furthermore, in those instances where a convention analogous to "at least one of A, B, and C, etc." is used, in general such a construction is intended in the sense one having skill in the art would understand the convention (e.g., "a system having at least one of A, B, and C" would include but not be limited to systems that have A alone, B alone, C alone, A and B together, A and C together, B and C together, and/or A, B, and C together, etc.). In those instances where a convention analogous to "at least one of A, B, or C, etc." is used, in general such a construction is intended in the sense one having skill in the art would understand the convention (e.g., "a system having at least one of A, B, or C" would include but not be limited to systems that have A alone, B alone, C alone, A and B together, A and C together, B and C together, and/or A, B, and C together, etc.). It will be further understood by those within the art that virtually any disjunctive word and/or phrase presenting two or more alternative terms, whether in the description, claims, or drawings, should be understood to contemplate the possibilities of including one of the terms, either of the terms, or both terms. For example, the phrase "A or B" will be understood to include the possibilities of "A" or "B" or "A and B."

While various aspects and embodiments have been disclosed herein, other aspects and embodiments will be apparent to those skilled in the art. The various aspects and embodiments disclosed herein are for purposes of illustration and are not intended to be limiting.

Moreover, the foregoing description and claims can refer to elements or features as being "connected" or "coupled" together. As used herein, unless expressly stated otherwise, "connected" means that one element/feature is directly or indirectly connected to another element/feature, and not necessarily mechanically. Likewise, unless expressly stated otherwise, "coupled" means that one element/feature is directly or indirectly coupled to another element/feature, and not necessarily mechanically. Thus, although the various schematics shown in the figures depict example arrangements of elements and components, additional intervening elements, devices, features, or components can be present in an actual embodiment (assuming that the functionality of the depicted circuits is not adversely affected).

**Claims**

1.  An electronically-implemented method for generating an estimate for a direct current (DC) offset in an RF transmitter, the method comprising:

    receiving samples of a first signal (r), wherein the first signal corresponds to a downconverted and filtered RF transmit signal ($s_t$) having an in-phase (I) channel and a quadrature (Q) channel;
    low-pass filtering and decimating the received samples of the first signal;
    retrieving values of a second signal (i) that correspond in time to the samples of the first signal, wherein the second signal includes an I-channel compensation signal ($l_i$), said compensation signal being a signal added to the I-channel baseband signal prior to upconverting to generate the RF transmit signal ($s_t$); generating an estimate of a I-channel DC offset ($i_{DC}$) induced by a first mixer (102); and
    adding the I-channel DC offset estimate ($i_{DC}$) to the I-channel of the RF transmit signal (Sti), **characterized in that** the method further comprises:

    receiving the low-pass filtered and decimated samples ($r_{ip}$) of the first signal at an averaging filter (310) and receiving an output of the averaging filter ($r_a$) at an integration filter (312), the I-channel DC offset ($i_{DC}$) being generated at least partly on two selected samples of the output (ri) of the integration filter (312) and the corresponding values of the second signal ($l_i$).

2.  The method of Claim 1, the method further comprising:

    retrieving values of a third signal ($l_q$) that correspond in time to the samples of the first signal, wherein the third signal includes a Q-channel compensation ($l_q$), said compensation signal being a signal added to the Q-channel baseband signal prior to upconverting to generate the RF transmit signal ($s_t$); generating an estimate of a Q-channel DC offset ($q_{DC}$) induced by a second mixer (106) based at least partly on at least two selected samples of the output (ri) of the integration filter (312) and the corresponding values of the third signal; and
    adding the Q-channel DC offset ($q_{DC}$) estimate to the Q-channel of the RF transmit signal ($S_t$, q).

3.  The method of any preceding Claim, further comprising generating the first signal (r), wherein the generating the first signal comprises using a calibrated downconverter (120) to downconvert the RF transmit signal after the RF transmit signal has been upconverted, wherein the downconverter receives first and second carrier signals that are received by the respective first and second mixers (102; 106).

4.  The method of any preceding Claim, wherein the generating the estimate of the I-channel DC offset ($i_{DC}$) is based at least partly on a selected mode of two or more modes of operation, wherein the two or more modes of operation include a calibration mode and a tracking mode.

5.  The method of Claim 4, wherein receiving samples of the first signal comprises:

    receiving a first sample of the first signal (r) by generating samples of the first signal after the second signal ($l_i$) takes on a first value for a first duration; and
    receiving a second sample of the first signal (r) by generating samples of the first signal after the second signal ($l_i$) takes on a second value for a second duration, wherein the first value is different than the second value,
    wherein the generating the estimate of the I-channel DC offset ($i_{DC}$) when the selected mode is the calibration mode is based at least partly on a first comparison between squared magnitudes of the first and second samples of the first signal (r) and based at least partly on a second comparison between the first and second values of the second signal ($l_i$).

6.  An apparatus for generating an estimate for a direct current (DC) offset in an RF transmitter comprising:

    an interface (122) configured to:

receive samples of a first signal (r) and values of a second signal that correspond in time to the samples of the first signal, wherein the first signal corresponds to a downconverted and filtered RF transmit signal ($s_t$) having an in-phase (I) channel and a quadrature (Q) channel, and wherein the second signal includes an I-channel compensation signal ($l_i$), said compensation signal being a signal added to the I-channel baseband signal prior to upconverting to generate the RF transmit signal ($s_t$); and

apply low-pass filtering decimation to the received samples of the first signal (r);

an offset estimator (124) configured to:

generate an estimate of an I-channel DC offset ($i_{DC}$) induced by a first mixer (102); and

add the I-channel DC offset ($i_{DC}$) estimate to the I-channel of the RF transmit signal, **characterized in that**:

the interface includes:

an averaging filter (310) configured to receive the low-pass filtered and decimated samples of the first signal; and

an integration filter (312) configured to receive an output of the averaging filter,

wherein the I-channel DC offset ($i_{DC}$) is generated at least partly on two selected samples of the output ($r_i$) of the integration filter (312) and the corresponding values of the second signal ($l_i$).

7. The apparatus of Claim 6, wherein the offset estimator (124) is configured to receive a first sample of the first signal (r) by generating the first sample after the second signal ($l_i$) takes on a first value for a first duration, and configured to receive a second sample of the first signal (r) by generating the first sample after the second signal ($l_i$) takes on a second value for a second duration, wherein the first value is different than the second value, wherein the offset estimator (124) is configured to generate the estimate of the I-channel DC offset ($i_{DC}$) based at least partly on a first comparison between a squared magnitudes of the first and second samples of the first signal (r) and based at least partly on a second comparison between the first and second values of the second signal ($l_i$).

8. The apparatus of Claim 6 or 7 wherein the offset estimator (124) is configured to selectively operate a tracking mode, wherein the offset estimator is configured to generate the estimate of the I-channel DC offset ($i_{DC}$) iteratively by generating a plurality of adjustments, wherein the adjustments are based at least partly on the at least two selected samples of the first signal and corresponding values of the second signal.

9. A computer program embodied in a tangible non-transitory computer-readable medium for generating an estimate for a direct current (DC) offset, the computer program comprising computer executable instructions that when executed on a data processor cause the data processor to perform the method of any one of claims 1 - 5:

**Patentansprüche**

1. Elektronisch implementiertes Verfahren zum Erzeugen einer Schätzung eines Gleichstromversatzes (DC-Versatz) in einem HF-Sender, wobei das Verfahren Folgendes umfasst:

Empfangen von Abtastwerten eines ersten Signals (r), wobei das erste Signal einem abwärts umgesetzten und gefilterten HF-Sendesignal ($s_t$) mit einem Inphase-Kanal (I-Kanal) und einem Quadratur-Kanal (Q-Kanal) entspricht;

Tiefpassfiltern und Untersetzen der empfangenen Abtastwerte des ersten Signals;

Wiedergewinnen von Werten eines zweiten Signals (i), die zeitlich den Abtastwerten des ersten Signals entsprechen, wobei das zweite Signal ein I-Kanal-Kompensationssignal ($l_i$) enthält, wobei das Kompensationssignal ein Signal ist, das vor der Aufwärtsumsetzung zu dem I-Kanal-Grundbandsignal addiert wird, um das HF-Sendesignal ($s_t$) zu erzeugen;

Erzeugen einer Schätzung eines I-Kanal-DC-Versatzes ($i_{DC}$), der durch einen ersten Mischer (102) induziert wird; und

Addieren der Schätzung des I-Kanal-DC-Versatzes ($i_{DC}$) zu dem I-Kanal des HF-Sendesignals ($s_{ti}$), **dadurch gekennzeichnet, dass** das Verfahren ferner Folgendes umfasst:

Empfangen der tiefpassgefilterten und untersetzten Abtastwerte ($r_{ip}$) des ersten Signals bei einem Mittelungsfilter (310) und Empfangen eines Ausgangs ($r_a$) des Mittelungsfilters bei einem Integrationsfilter (312), wobei der I-Kanal-DC-Versatz ($i_{DC}$) wenigstens teilweise an zwei ausgewählten Abtastwerten des Ausgangs ($r_i$) des Integrationsfilters (312) und den entsprechenden Werten des zweiten Signals ($l_i$) erzeugt wird.

2. Verfahren nach Anspruch 1, wobei das Verfahren ferner Folgendes umfasst:

Wiedergewinnen von Werten eines dritten Signals ($l_q$), die zeitlich den Abtastwerten des ersten Signals entsprechen, wobei das dritte Signal ein Q-Kanal-Kompensationssignal ($l_q$) enthält, wobei das Kompensationssignal ein Signal ist, das vor der Aufwärtsumsetzung zu dem Q-Kanal-Grundbandsignal addiert wird, um das HF-Sendesignal ($s_t$) zu erzeugen;
Erzeugen einer Schätzung eines Q-Kanal-DC-Versatzes ($q_{DC}$), der durch einen zweiten Mischer (106) induziert wird, wenigstens teilweise anhand von zwei ausgewählten Abtastwerten des Ausgangs ($r_i$) des Integrationsfilters (312) und der entsprechenden Werte des dritten Signals; und
Addieren der Schätzung des Q-Kanal-DC-Versatzes ($q_{DC}$) zu dem Q-Kanal des HF-Sendesignals ($s_t$, q).

3. Verfahren nach einem vorhergehenden Anspruch, das ferner das Erzeugen des ersten Signals (r) umfasst, wobei das Erzeugen des ersten Signals die Verwendung eines kalibrierten Abwärtsumsetzers (120) umfasst, um das HF-Sendesignal abwärts umzusetzen, nachdem das HF-Sendesignal aufwärts umgesetzt worden ist, wobei der Abwärtsumsetzer erste und zweite Trägersignale empfängt, die von dem ersten bzw. dem zweiten Mischer (102; 106) empfangen werden.

4. Verfahren nach einem vorhergehenden Anspruch, wobei das Erzeugen der Schätzung des I-Kanal-DC-Versatzes ($i_{DC}$) wenigstens teilweise auf einer ausgewählten Betriebsart von zwei oder mehr Betriebsarten beruht, wobei die zwei oder mehr Betriebsarten eine Kalibrierungsbetriebsart und eine Nachverfolgungsbetriebsart umfassen.

5. Verfahren nach Anspruch 4, wobei das Empfangen von Abtastwerten des ersten Signals Folgendes umfasst:

Empfangen eines ersten Abtastwerts des ersten Signals (r) durch Erzeugen von Abtastwerten des ersten Signals, nachdem das zweite Signal ($l_i$) für eine erste Dauer einen ersten Wert angenommen hat; und
Empfangen eines zweiten Abtastwerts des ersten Signals (r) durch Erzeugen von Abtastwerten des ersten Signals, nachdem das zweite Signal ($l_i$) für eine zweite Dauer einen zweiten Wert angenommen hat, wobei der erste Wert von dem zweiten Wert verschieden ist,
wobei das Erzeugen der Schätzung des I-Kanal-DC-Versatzes ($i_{DC}$) dann, wenn die ausgewählte Betriebsart die Kalibrierungsbetriebsart ist, wenigstens teilweise auf einem ersten Vergleich zwischen quadrierten Größen des ersten und des zweiten Abtastwerts des ersten Signals (r) beruht und wenigstens teilweise auf einem zweiten Vergleich zwischen dem ersten und dem zweiten Wert des zweiten Signals ($l_i$) beruht.

6. Vorrichtung zum Erzeugen einer Schätzung für einen Gleichstromversatz (DC-Versatz) in einem HF-Sender, die Folgendes umfasst:

eine Schnittstelle (122), die konfiguriert ist zum:

Empfangen von Abtastwerten eines ersten Signals (r) und von Werten eines zweiten Signals, die zeitlich den Abtastwerten des ersten Signals entsprechen, wobei das erste Signal einem abwärts umgesetzten und gefilterten HF-Sendesignal ($s_t$) mit einem Inphase-Kanal (I-Kanal) und einem Quadratur-Kanal (Q-Kanal) entspricht und wobei das zweite Signal ein I-Kanal-Kompensationssignal ($l_i$) enthält, wobei das Kompensationssignal ein Signal ist, das vor der Aufwärtsumsetzung zu dem I-Kanal-Grundbandsignal addiert wird, um das HF-Sendesignal ($s_t$) zu erzeugen; und
Anwenden einer Tiefpassfilterung und einer Untersetzung auf die empfangenen Abtastwerte des ersten Signals (r);

eine Versatz-Schätzeinrichtung (124), die konfiguriert ist zum:

Erzeugen einer Schätzung eines I-Kanal-DC-Versatzes ($i_{DC}$), der durch einen ersten Mischer (102) induziert wird; und
Addieren der Schätzung des I-Kanal-DC-Versatzes ($i_{DC}$) zu dem I-Kanal des HF-Sendesignals, **dadurch gekennzeichnet, dass**:

die Schnittstelle Folgendes umfasst:

ein Mittelungsfilter (310), das konfiguriert ist, die tiefpassgefilterten und untersetzten Abtastwerte des ersten Signals zu empfangen; und

ein Integrationsfilter (312), das konfiguriert ist, einen Ausgang des Mittelungsfilters zu empfangen, wobei der I-Kanal-DC-Versatz ($i_{DC}$) wenigstens teilweise an zwei ausgewählten Abtastwerten des Ausgangs ($r_i$) des Integrationsfilters (312) und den entsprechenden Werten des zweiten Signals ($l_i$) erzeugt wird.

7. Vorrichtung nach Anspruch 6, wobei die Versatz-Schätzeinrichtung (124) konfiguriert ist, einen ersten Abtastwert des ersten Signals (r) durch Erzeugen des ersten Abtastwerts, nachdem das zweite Signal ($l_i$) für eine erste Dauer einen ersten Wert angenommen hat, zu empfangen, und konfiguriert ist, einen zweiten Abtastwert des ersten Signals (r) durch Erzeugen des ersten Abtastwerts, nachdem das zweite Signal ($l_i$) für eine zweite Dauer einen zweiten Wert angenommen hat, zu empfangen, wobei der erste Wert von dem zweiten Wert verschieden ist, wobei die Versatzschätzeinrichtung (124) konfiguriert ist, die Schätzung des I-Kanal-DC-Versatzes ($i_{DC}$) wenigstens teilweise anhand eines ersten Vergleichs zwischen quadrierten Größen des ersten und des zweiten Abtastwerts des ersten und des zweiten Signals (r) und wenigstens teilweise anhand eines zweiten Vergleichs zwischen dem ersten und dem zweiten Wert des zweiten Signals ($l_i$) zu erzeugen.

8. Vorrichtung nach Anspruch 6 oder 7, wobei die Versatz-Schätzeinrichtung (124) konfiguriert ist, wahlweise eine Verfolgungsbetriebsart auszuführen, wobei die VersatzSchätzeinrichtung konfiguriert ist, die Schätzung des I-Kanal-DC-Versatzes ($i_{DC}$) iterativ durch Erzeugen mehrerer Einstellungen zu erzeugen, wobei die Einstellungen wenigstens teilweise auf den wenigstens zwei ausgewählten Abtastwerten des ersten Signals und entsprechenden Werten des zweiten Signals beruhen.

9. Computerprogramm, das in einem gegenständlichen, nichttransitorischen computerlesbaren Medium verkörpert ist, um eine Schätzung für einen GleichstromVersatz (DC-Versatz) zu erzeugen, wobei das Computerprogramm computerausführbare Befehle enthält, die dann, wenn sie in einem Datenprozessor ausgeführt werden, den Datenprozessor dazu veranlassen, das Verfahren nach einem der Ansprüche 1-5 auszuführen.

**Revendications**

1. Procédé mis en oeuvre électroniquement pour générer une estimation pour un décalage de courant continu (CC) dans un émetteur RF, le procédé comprenant :

- la réception d'échantillons d'un premier signal (r), dans lequel le premier signal correspond à un signal de transmission RF converti à la baisse et filtré ($s_t$) ayant un canal en phase (I) et un canal en quadrature (Q) ;
- le filtrage passe-bas et la décimation des échantillons reçus du premier signal ;
- l'extraction de valeurs d'un deuxième signal (i) qui correspondent en temps aux échantillons du premier signal, dans lequel le deuxième signal comprend un signal de compensation de canal I ($l_i$), ledit signal de compensation étant un signal ajouté au signal de bande de base de canal I avant conversion à la hausse afin de générer le signal de transmission RF ($s_t$) ;
- la génération d'une estimation d'un décalage de CC de canal I ($i_{DC}$) induit par un premier mélangeur (102) ; et
- l'ajout de l'estimation de décalage de CC de canal I ($i_{DC}$) au canal I du signal de transmission RF (Sti), **caractérisé en ce que** le procédé comprend en outre :

- la réception des échantillons filtrés passe-bas et décimés ($r_{ip}$) du premier signal au niveau d'un filtre de moyenne (310) et la réception d'une sortie du filtre de moyenne ($r_a$) au niveau d'un filtre d'intégration (312), le décalage de CC de canal I ($i_{DC}$) étant généré au moins en partie sur deux échantillons sélectionnés de la sortie (ri) du filtre d'intégration (312) et les valeurs correspondantes du deuxième signal ($l_i$).

2. Procédé selon la revendication 1, le procédé comprenant en outre :

- l'extraction de valeurs d'un troisième signal ($l_q$) qui correspondent en temps aux échantillons du premier signal, dans lequel le troisième signal comprend une compensation de canal Q ($l_q$), ledit signal de compensation étant un signal ajouté au signal de bande de base de canal Q avant conversion à la hausse afin de générer le signal de transmission RF ($s_t$) ;

- la génération d'une estimation d'un décalage de CC de canal Q ($q_{DC}$) induit par un deuxième mélangeur (106) sur la base au moins en partie d'au moins deux échantillons sélectionnés de la sortie (ri) du filtre d'intégration (312) et des valeurs correspondantes du troisième signal ; et
- l'ajout de l'estimation de décalage de CC de canal Q ($q_{DC}$) au canal Q du signal de transmission RF (St, q).

3. Procédé selon l'une quelconque des revendications précédentes, comprenant en outre la génération du premier signal (r), dans lequel la génération du premier signal comprend l'utilisation d'un convertisseur à la baisse étalonné (120) pour convertir à la baisse le signal de transmission RF après que le signal de transmission RF a été converti à la hausse, dans lequel le convertisseur à la baisse reçoit des premier et deuxième signaux porteurs qui sont reçus par les premier et deuxième mélangeurs respectifs (102 ; 106).

4. Procédé selon l'une quelconque des revendications précédentes, dans lequel la génération de l'estimation du décalage de CC de canal I ($i_{DC}$) est basée au moins en partie sur un mode sélectionné de deux, ou plus, modes de fonctionnement, dans lequel les deux, ou plus, modes de fonctionnement comprennent un mode étalonnage et un mode suivi.

5. Procédé selon la revendication 4, dans lequel la réception d'échantillons du premier signal comprend :

- la réception d'un premier échantillon du premier signal (r) en générant des échantillons du premier signal après que le deuxième signal ($l_i$) a pris une première valeur pendant une première durée ; et
- la réception d'un deuxième échantillon du premier signal (r) en générant des échantillons du premier signal après que le deuxième signal ($l_i$) a pris une deuxième valeur pendant une deuxième durée, dans lequel la première valeur est différente de la deuxième valeur,

dans lequel la génération de l'estimation du décalage de CC de canal I ($i_{DC}$) quand le mode sélectionné est le mode étalonnage est basée au moins en partie sur une première comparaison entre des grandeurs mises au carré des premier et deuxième échantillons du premier signal (r) et basée au moins en partie sur une deuxième comparaison entre les première et deuxième valeurs du deuxième signal ($l_i$).

6. Appareil pour générer une estimation pour un décalage de courant continu (CC) dans un émetteur RF comprenant :

- une interface (122) configurée pour :

. recevoir des échantillons d'un premier signal (r) et des valeurs d'un deuxième signal qui correspondent en temps aux échantillons du premier signal, dans lequel le premier signal correspond à un signal de transmission RF converti à la baisse et filtré ($s_t$) ayant un canal en phase (I) et un canal en quadrature (Q), et dans lequel le deuxième signal comprend un signal de compensation de canal I ($l_i$), ledit signal de compensation étant un signal ajouté au signal de bande de base de canal I avant conversion à la hausse afin de générer le signal de transmission RF ($s_t$) ; et
. appliquer une décimation par filtrage passe-bas aux échantillons reçus du premier signal (r) ;

- un estimateur de décalage (124) configuré pour :

. générer une estimation d'un décalage de CC de canal I ($i_{DC}$) induit par un premier mélangeur (102) ; et
. ajouter l'estimation de décalage de CC de canal I ($i_{DC}$) au canal I du signal de transmission RF, **caractérisé en ce que** :

l'interface comprend :

- un filtre de moyenne (310) configuré pour recevoir les échantillons filtrés passe-bas et décimés du premier signal ; et
- un filtre d'intégration (312) configuré pour recevoir une sortie du filtre de moyenne,

dans lequel le décalage de CC de canal I ($i_{DC}$) est généré au moins en partie sur deux échantillons sélectionnés de la sortie ($r_i$) du filtre d'intégration (312) et les valeurs correspondantes du deuxième signal ($l_i$).

7. Appareil selon la revendication 6, dans lequel l'estimateur de décalage (124) est configuré pour recevoir un premier échantillon du premier signal (r) en générant le premier échantillon après que le deuxième signal ($l_i$) a pris une

première valeur pendant une première durée ; et configuré pour recevoir un deuxième échantillon du premier signal (r) en générant le premier échantillon après que le deuxième signal ($l_i$) a pris une deuxième valeur pendant une deuxième durée, dans lequel la première valeur est différente de la deuxième valeur,
dans lequel l'estimateur de décalage (124) est configuré pour générer l'estimation de décalage de CC de canal I ($i_{DC}$) sur la base au moins en partie d'une première comparaison entre des grandeurs mises au carré des premier et deuxième échantillons du premier signal (r) et sur la base au moins en partie d'une deuxième comparaison entre les première et deuxième valeurs du deuxième signal ($l_i$).

8. Appareil selon la revendication 6 ou 7, dans lequel l'estimateur de décalage (124) est configuré pour actionner sélectivement un mode suivi, dans lequel l'estimateur de décalage est configuré pour générer l'estimation de décalage de CC de canal I ($i_{DC}$) de manière itérative en générant une pluralité d'ajustements, dans lequel les ajustements sont basés au moins en partie sur les aux moins deux échantillons sélectionnés du premier signal et valeurs correspondantes du deuxième signal.

9. Programme informatique incorporé dans un support lisible par ordinateur non transitoire tangible pour générer une estimation pour un décalage de courant continu (CC), le programme informatique comprenant des instructions exécutables par ordinateur qui, lorsqu'elles sont exécutées sur un processeur de données, amènent le processeur de données à effectuer le procédé selon l'une quelconque des revendications 1 à 5.

**Fig. 1**

*Fig. 2*

**Fig. 3**

126

$u_i$

$-i_{DC}$

$l_i$

$l_{i,aux}$

402

$u_q$

$-q_{DC}$

$l_q$

$l_{q,aux}$

404

*Fig. 4*

*500*

*504*

PROCESSOR

*514*

*512*

MEMORY

SIGNAL PREPROCESSING
MODULE

*516*

*506*

DAC/ADC

OFFSET ESTIMATOR
MODULE

*522*

*518*

CALIBRATION
MODULE

*524*

TRACKING MODULE

*508*

TRANSMITTER CIRCUITRY

COMPENSATOR MODULE

*520*

*510*

DATA STORAGE DEVICE

*Fig. 5*

*600*

*602*

Start

*604*

Receive samples of a first signal

*606*

Retrieve values of a second signal, wherein the second signal comprises a component in a third signal, wherein the third signal is upconverted, downconverted, and filtered to generate the first signal

*608*

Generate an estimate of a first DC offset induced by an upconverter based at least partly on at least two selected samples of the first signal and corresponding values of the second signal

*610*

End

*Fig. 6*

*608*

*702*

Start

*704*

Calibrated?

YES

NO

*706*

Set Sampler To
CALIBRATION MODE

*710*

Set sampler to TRACKING
MODE

*708*

Estimate DC offset
calibration

*712*

Estimate DC offset
adjustment

*714*

End

*Fig. 7*

708

## Calibration

802 — ( Start )

804

Select at least two different compensation signals

806

For each of the at least two compensation signals, receive a sample of a filtered version of a demodulated transmit signal generated with the corresponding compensation signal

808

Generate an estimate of the DC offset calibration by performing a calculation involving the at least two samples and the at least two different compensation signals

810

( End )

## Fig. 8

900

## Sampling Schedule

| | $q_{DC}$ | | $i_{DC}$ |
| --- | --- | --- | --- |
| | 902 | 904 | 906 |
| Sample | $x_1$ | $x_2$ | $x_3$ |
| Compensation signals | $l_{i1}$ | $l_{i1}$ | $l_{i2}$ |
| | $l_{q1}$ | $l_{q2}$ | $l_{q2}$ |
| | T1 | T2 | T3 |

## Fig. 9

*712*

## Tracking

*1002*

Start

*1004*

Receive a plurality of samples of a filtered version of a demodulated transmit signal

*1006*

Generate an estimate of the DC offset adjustment by updating the adjustment based at least on the plurality of samples and corresponding compensation signals

*1008*

NO

Tracking complete?

YES

*1010*

End

## *Fig. 10*

## REFERENCES CITED IN THE DESCRIPTION

**Patent documents cited in the description**

- US 6801581 B
- US 200200018531 A1
- US 7382833 B1
- US 7035589 B1